# EUROPEAN PATENT SPECIFICATION

(11) **EP 4 191 745 B1**
(45) Date of publication and mention of the grant of the patent: **23.09.2026**
(21) Application number: 21851285.3
(22) Date of filing: 20.07.2021
(51) Int. Cl.: H01M 10/48, B60L 3/00, B60L 53/10, B60L 58/12, B60L 58/16, G01R 31/382, G01R 31/385, G01R 31/387, G01R 31/389, G01R 31/392, G16Y 10/40, G16Y 20/20, G16Y 40/20, H02J 7/00, H02J 7/02, H02J 7/04, H02J 7/10, G01R 31/396, G01R 31/367, B60L 3/12, H01M 10/42, B60L 58/22, G01R 31/3842, G01R 31/374

(54) **BATTERY PACK DIAGNOSING METHOD, AND BATTERY PACK DIAGNOSING DEVICE**
VERFAHREN ZUR DIAGNOSE EINES BATTERIEPACKS, UND VORRICHTUNG ZUR DIAGNOSE EINES BATTERIEPACKS
PROCÉDÉ DE DIAGNOSTIC DE BLOC-BATTERIE, ET DISPOSITIF DE DIAGNOSTIC DE BLOC-BATTERIE

(30) Priority: 30.07.2020 JP 2020129499
(43) Date of publication of application: 07.06.2023
(73) Proprietor: HITACHI HIGH-TECH CORPORATION, Tokyo 105-6409 (JP)
(72) Inventor: INOUE, Takeshi, Tokyo 100-8280 (JP); HIRASAWA, Shigeki, Tokyo 105-6409 (JP); ISHIMARU, Tetsuya, Tokyo 105-6409 (JP); HONKURA, Kohei, Tokyo 100-8280 (JP); MAKINO, Shigeki, Tokyo 100-8280 (JP); KAWAJI, Jun, Tokyo 100-8280 (JP)
(74) Representative: MERH-IP Matias Erny Reichl Hoffmann Patentanwälte PartG mbB
(86) International application number: PCT/JP2021/027197
(87) International publication number: WO 2022/024885

(56) References cited:
- EP-A1- 3 611 524
- WO-A1-2016/075797
- WO-A1-2017/199629
- JP-A- 2019 049 412
- JP-A- 2020 038 812
- US-A1- 2013 314 050
- US-A1- 2018 083 298
- OMARIBA ZACHARY BOSIRE ET AL: "Review of Battery Cell Balancing Methodologies for Optimizing Battery Pack Performance in Electric Vehicles", IEEE ACCESS, vol. 7, 12 September 2019 (2019-09-12), pages 129335 - 129352, XP011746578, DOI: 10.1109/ACCESS.2019.2940090

## Description

### Technical Field

The present invention relates to a battery pack diagnosing method, and a battery pack diagnosing device.

### Background Art

A battery pack including a plurality of cells is built in an electric vehicle (EV) and the like. Since such a battery pack needs to be replaced at appropriate times, there is a demand for a technique for accurately predicting the life of battery packs.

JP2009-210284A (PTL 1) discloses a device that calculates and displays the remaining capacity of an assembled battery based on a charging capacity that each cell can discharge up to a discharge stop voltage and a charge capacity that the assembled battery can discharge up to the minimum guaranteed output final voltage.

In this specification, the state of charge of each cell in the battery packp is called "SOC". Further, an open circuit voltage is called "OCV".
NPTL 2 discloses methodologies, as hybrid scheme, for optimizing battery pack performance in electric vehicles.

### Citation List

### Patent Literature

PTL 1: JP2009-210284A
NPTL 2: OMARIBA ZACHARY BOSIRE ET AL: "Review of Battery Gell Balancing Methodologies for Optimizing Battery Pack Performance in Electric Vehicles", IEEE ACCESS, vol. 7, pages 129335-129352.

### Summary of Invention

### Technical Problem

Information on the SOC of each cell in the battery pack is required to calculate the energy capacity of the battery pack.

Communication data from an EV and the like often contain only SOC information of one cell as a representative SOC of the battery pack and does not contain SOC information of other cells. This is because a battery management unit selects one of the cells in the battery pack to measure the SOC, but it is unclear which cell is selected.

For that reason, when the energy capacity of the battery pack is calculated using the representative SOC of the battery pack in a state where the voltages of the cells in the battery pack are not uniform (i.e., unbalance state), there is a problem that a calculation error of the energy capacity increases.

An object of the present invention is to accurately calculate the energy capacity of the battery pack even in an unbalance state.

### Solution to Problem

The above cited problem is solved in accordance with the appended set of claims. According to the claimed invention, a method for diagnosing a battery pack having a configuration in which a plurality of cells are connected in series, using a system for obtaining detected data including the current and temperature of the battery pack and the voltage of each cell, the method comprising: a step of calculating an electric charge capacity and a SOC of each cell, using the current and the temperature, the voltage of each cell, an OCV-SOC function, and a resistance table, and calculating an amount of unbalance, which is an estimated value of the SOC, and a resistance of each cell when the battery pack is fully charged; and a step of calculating the energy capacity of the battery pack using the electric charge capacity, the amount of unbalance, and the resistance, wherein coefficients of the electric charge capacity, an initial value of the SOC, and the resistance of each of the cells that minimize a difference between an estimated voltage and an actual voltage of each of the cells are obtained.

According to another aspect of the claimed invention, a device for diagnosing a battery pack, comprising: a SOC calculation unit; a battery pack energy capacity calculation unit; and a storage device having a resistance table, wherein the SOC calculation unit calculates an electric charge capacity and the SOC of each cell using the current and temperature of the battery pack having a configuration in which a plurality of cells are connected in series, a voltage of each cell, an OCV-SOC function, and the resistance table, and calculates an amount of unbalance, which is an estimated value of the SOC, and a resistance of each cell when the battery pack is fully charged, and the battery pack energy capacity calculation unit calculates the energy capacity of the battery pack using the electric charge capacity, the amount of unbalance, and the resistance, wherein coefficients of the electric charge capacity, an initial value of the SOC, and the resistance of each of the cells that minimize a difference between an estimated voltage and an actual voltage of each of the cells are obtained. Preferential embodiments are disclosed according to claims 2-18.

### Advantageous Effects of Invention

According to the present invention, it is possible to accurately calculate the energy capacity of the battery pack even in an unbalance state.

### Brief Description of Drawings

[Fig. 1] Fig. 1 is a schematic configuration diagram illustrating an example of a battery pack diagnosing system according to a first embodiment.
[Fig. 2] Fig. 2 is a configuration diagram illustrating an example of a battery pack built into an EV.
[Fig. 3] Fig. 3 is a table illustrating an example of communication contents from the EV to a server.
[Fig. 4] Fig. 4 is a schematic configuration diagram illustrating an example of a battery table in Fig. 1.
[Fig. 5] Fig. 5 is a flowchart illustrating an example of processing in a SOC calculating means 107 of Fig. 1.
[Fig. 6] Fig. 6 is a flowchart illustrating an example of processing in a battery pack energy capacity calculating means 108 of Fig. 1.
[Fig. 7A] Fig. 7A is a graph illustrating the voltage of each cell in an unbalance state in the battery pack.
[Fig. 7B] Fig. 7B is a graph illustrating the voltage of each cell in a state where the unbalance state of the battery pack is eliminated.
[Fig. 8] Fig. 8 is a flowchart illustrating an example of a method for setting an OCV of a battery table in a battery pack diagnosing system.
[Fig. 9] Fig. 9 is a diagram illustrating an example of performing function approximation on the OCV of a battery table using a discharge curve analysis.
[Fig. 10] Fig. 10 is a flowchart illustrating an example of a method for calculating the replacement time of the battery pack.
[Fig. 11] Fig. 11 is a table illustrating an example of a battery capacity table.
[Fig. 12] Fig. 12 is a table illustrating an example of a battery diagnosis result table.

### Description of Embodiments

In the present disclosure, the automatic generation of a table and the calculation of the energy capacity of the battery pack are performed. The present disclosure includes a method for transferring data of a battery pack built in an EV to a server and diagnosing the deterioration of the battery pack in the server and the like.

Regarding a device for performing this diagnosing method, there are a pattern of performing a calculation on the server, a pattern of performing calculation only on a terminal inside the EV, and a pattern of performing a calculation on both the server and the terminal inside the EV. A series of these means may be implemented as a program within the server or may be implemented using a program of only the terminal within the EV, or a program of both the terminal of the EV and the server.

However, the present disclosure is not limited to the following embodiments and includes various modifications, which are within the technical concept of the present disclosure,i.e. within its scope defined by the appended claims. For example, the battery pack diagnosing system described below can be applied not only to the EV, but also to battery packs for home energy management systems (HEMS), building energy management systems (BEMS), factory energy management systems (FEMS), railroads, and construction machinery.

Embodiments of the present disclosure will be described in detail below with reference to the drawings.

### (First Embodiment)

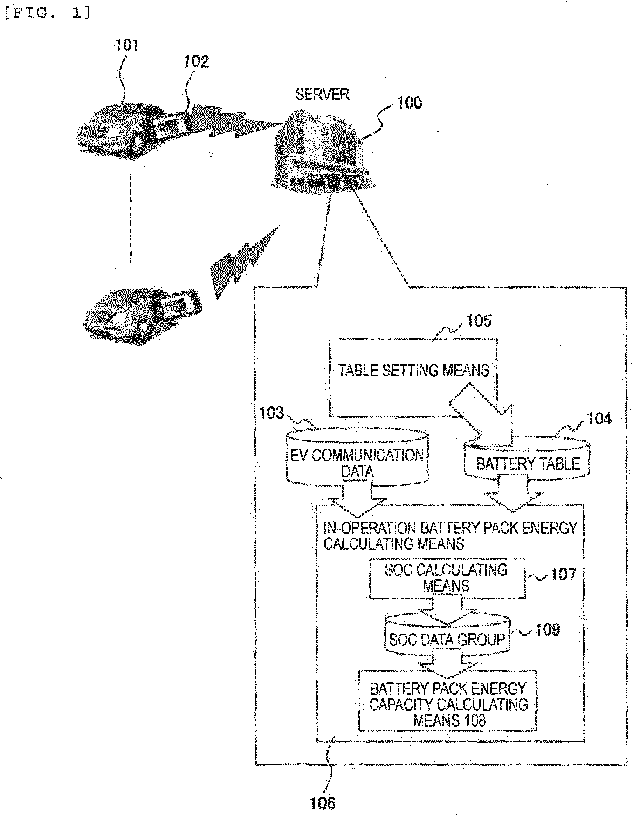

Fig. 1 is a schematic configuration diagram illustrating an example of the battery pack diagnosing system according to this embodiment.

In this drawing, a battery pack diagnosing system includes a server 100 (also referred to as a "computing device" or "diagnosing device"), a plurality of electric vehicles (EV) 101, and a communication device 102 (for example, a mobile terminal such as smartphone, a Wi-Fi (registered trademark) router, an in-vehicle computer such as a car navigation system, and the like) in each EV, as components. The server 100 includes a storage device 103 (a first storage device) for accumulating EV communication data (the types of data will be described later) collected from each EV via the communication device 102, a second storage device for storing a battery table 104, a table setting means 105 (table setting unit), and an in-operation battery pack energy calculating means 106 (in-operation battery pack energy calculation unit). The in-operation battery pack energy calculating means 106 includes a SOC calculating means 107 (SOC calculation unit), a battery pack energy capacity calculating means 108 (battery pack energy capacity calculation unit), and a third storage device that stores SOC data group 109.

That is, it consists of two phases including an initial setting phase (table setting means 105 for automatic table setting) and an in-operation phase (in-operation battery pack energy calculating means 106 for calculating SOC and energy capacity). The initial setting phase will be described in detail in second and third embodiments. The in-operation phase will be described in the first embodiment. If an OCV table, a charge resistance table, and a discharge resistance table are set by measuring and calculating the electrical characteristics of the battery in advance, the initial setting phase is unnecessary and only the in-operation phase is performed.

In addition, although this embodiment and Fig. 1 are examples in which calculation is performed on the server, the calculation may be performed at an edge such as in-vehicle BMU or in-vehicle smartphone, or calculation may be performed on the server and an edge such as the in-vehicle BMU or in-vehicle smartphone. When performing calculations by both the server and the in-vehicle BMU or in-vehicle smartphone, a diagnosing system constructed and improved from a large amount of data in a cloud may be sent to the edge side.

In this diagnosing method, the SOC of each cell is calculated from the OCV table and the charge resistance table using communication data obtained while the battery pack is being charged by a charger. In this case, the OCV table is a table in which a SOC value is associated with the OCV, and can be called an "OCV-SOC function". The communication data is detected data obtained from the EV via a communication device. Then, using the SOC of each cell, the electric charge capacity of each cell (hereinafter referred to as "Ah capacity"), an estimated value of the SOC of each cell when the battery pack is fully charged (hereinafter referred to as "amount of unbalance"), and the resistance are obtained.

In Fig. 1, although the battery pack is built into the EV, the present disclosure is not limited thereto, and the battery pack may be fixated on as a -stationary power storage device. Further, the diagnosing device is not limited to being installed outside the EV and may be installed inside the EV.

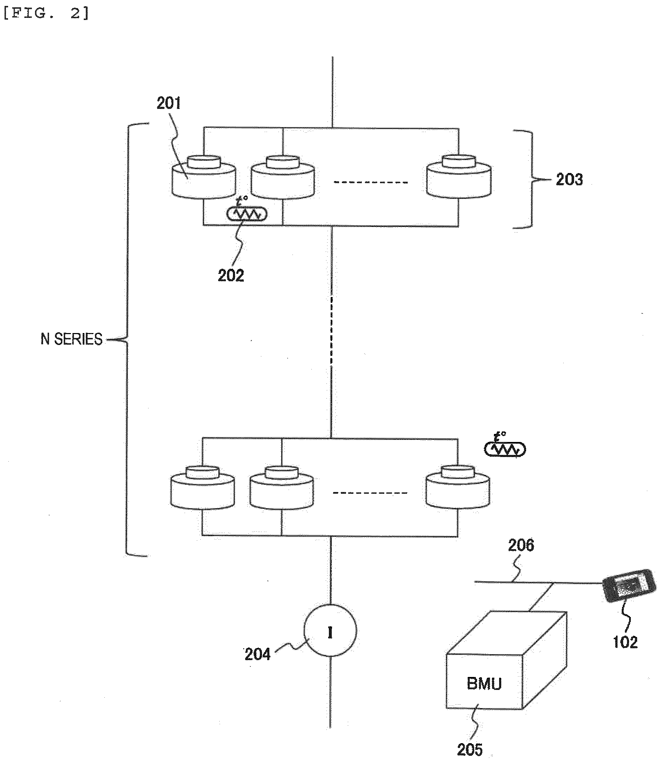

Fig. 2 is a configuration diagram illustrating an example of the battery pack built into the EV.

The battery pack has a configuration in which N cell groups 203 each having L cells 201 connected in parallel are connected in series. Here, the cell group 203 is regarded as one battery cell. One temperature sensor 202 is attached to each of the selected M cell groups 203. In other words, M temperature sensors 202 are arranged in the battery pack.

A battery management unit 205 (BMU) that manages the battery pack is also built into the EV. The BMU collects the voltage of each of the cell groups 203 connected in parallel, the current measured by an ammeter (current sensor) 204, and the temperature measured by the M temperature sensors 202 via a network 206 (LAN) inside the EV and calculates a representative SOC of the battery pack. The BMU can transmit information (detected data) such as the current, voltage, temperature, and representative SOC of the battery pack to the communication device 102 via the LAN. The communication device 102 receives and transmits such information to the server 100 (Fig. 1). This transmission communicates information to the server periodically while the ignition of the EV is turned on. This communication interval may be, for example, approximately 1 second, or may be a longer interval of 5 seconds or greater.

In summary, the detected data may be acquired at time intervals of less than 5 seconds or may be acquired at time intervals of 5 seconds or greater.

Next, the contents of communication sent from the communication device to the server will be described.

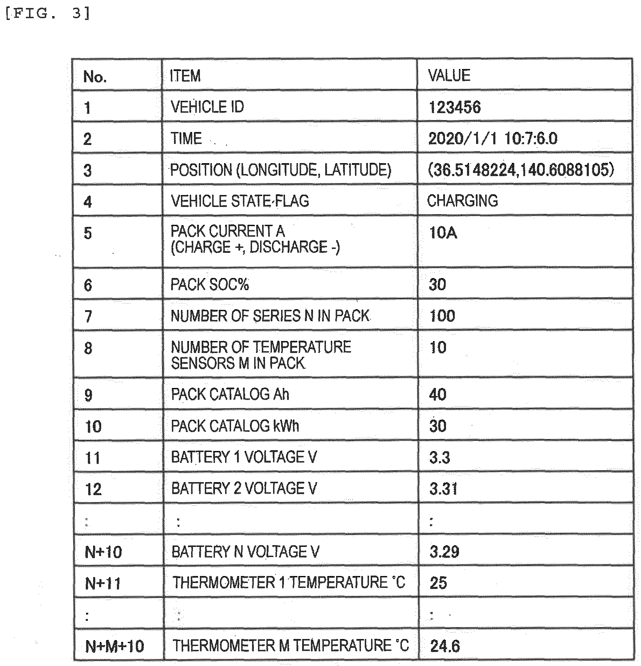

Fig. 3 is a table illustrating an example of communication contents from the EV to the server.

In this drawing, the vehicle ID of No. 1 indicates an identification ID of the EV. The time of No. 2 indicates the time when the current, voltage, and temperature of the battery are measured, not the transmission time. The position of No. 3 indicates the longitude and latitude of the position of the EV at the time when the current, voltage, and temperature of the battery were measured. The vehicle state flag of No. 4 is a flag indicating whether the EV is charging, stopped, or traveling. In this example, the battery pack current of No. 5 is a value in which the charging side is positive, and indicates the current at the time of No. 2. The SOC of the battery pack of No. 6 indicates the representative SOC of the battery pack. The number of series N in the battery pack of No. 7 is the number of series of cells illustrated in Fig. 2. The number M of temperature sensors in the battery pack of No. 8 is the number of temperature sensors illustrated in Fig. 2. The battery pack catalog Ah of No. 9 indicates a value of cell catalog Ah x number of parallels L of the cells illustrated in Fig. 2. The battery pack catalog kWh of No. 10 is obtained by converting the value of the catalog energy capacity of the cell x number of series N x number of parallels L to kWh. No. 11 to No. (N + 10) indicate the voltages of the cells with the number of parallels L illustrated in Fig. 2. No. (N + 11) to No. (N + M + 10) indicate the temperatures of the temperature sensors, respectively. The voltage and temperature are the values measured at the time of No. 2. No. 3 and No. 6 to No. 10 are not necessarily essential for communication. If No. 7 to No. 10 are absent, information of No. 7 to No. 10 of each EV is assumed to be present on the server side.

In the storage device 103 illustrated in Fig. 1, communication data (EV communication data) at regular time intervals as illustrated in Fig. 3 are accumulated.

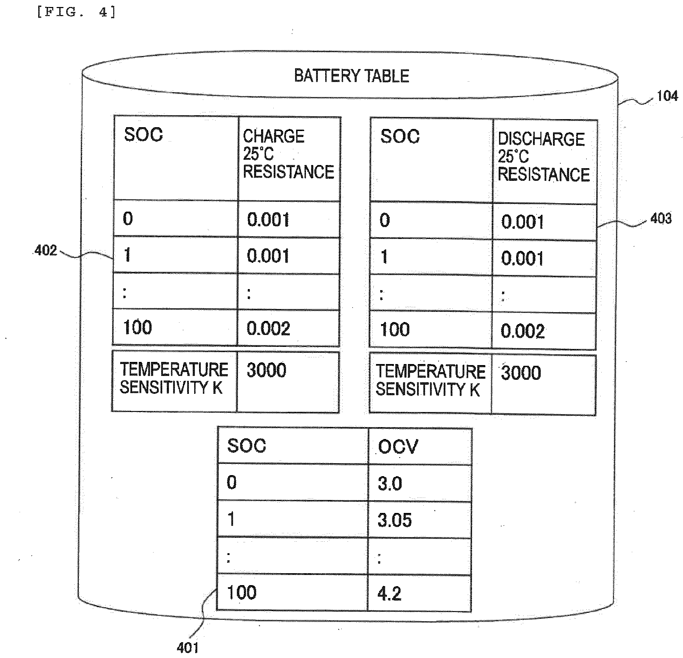

Fig. 4 is a schematic configuration diagram illustrating an example of the battery table of Fig. 1.

In Fig. 1, the battery table 104 is a table set in advance or set by the table setting means 105 and referred to by the in-operation battery pack energy calculating means 106. The first embodiment will be described assuming that the battery table is set. A detailed setting method will be described in the second and third embodiments.

As illustrated in Fig. 4, the battery table 104 includes an OCV table 401, a charge resistance table 402, and a discharge resistance table 403. Here, the charge resistance and discharge resistance are functions of the SOC and temperature.

The OCV table 401 is a function that has a value corresponding to each SOC. The discharge resistance table 403, in this example, has a value at 25°C for each SOC and has temperature sensitivity.

Here, a discharge resistance R_{d}(T_{cell}) at a cell temperature T_{cell}[°C] is expressed by the following formula (1).
[Formula 1] ${R}_{d} \left({T}_{cell}\right) = exp \left\{B/\left({T}_{cell}+273.15\right)-B/\left(25+273.15\right)\right\} \times {R}_{d} \left(25°C\right)$

In the formula, R_{d}(25°C) is the discharge resistance R_{d}(T_{cell}) at T_{cell} = 25°C. Also, B is the temperature sensitivity.

The charge resistance is also expressed in the same way as the discharge resistance R_{d}(T_{cell}).

Next, a method for diagnosing the deterioration of the battery pack will be described. Here, the deterioration diagnosis is a process in the in-operation battery pack energy calculating means 106 of Fig. 1 and is simply to obtain the energy capacity of the battery pack.

First, the server calculates the SOC of each cell, then calculates the electric charge capacity, the amount of unbalance of each cell, the current energy capacity of the battery pack, and the energy capacity in a state where the unbalance is eliminated (the state where the SOC of all batteries is 100% when the battery pack is fully charged).

Finally, an approximation function with time as an argument is estimated from the data group of the energy capacity of the battery pack and time pairs, the approximation function is extrapolated on the time axis to calculate the time when the battery pack reaches the energy capacity to be replaced, and the replacement time is notified.

Hereinafter, the in-operation battery pack energy calculating means 106 illustrated in Fig. 1 will be described in detail.

The operation phase of the in-operation battery pack energy calculating means 106 is divided into two phases.

First, the SOC calculating means 107 obtains the SOC of each cell and accumulates SOC data in a database (DB) of the SOC data group 109. Then, the battery pack energy capacity calculating means 108 obtains the energy capacity of the battery pack using the SOC data group 109. The in-operation battery pack energy calculating means 106 calculates based on the battery table 104 and data in the storage device 103.

Each of the SOC calculating means 107 and the battery pack energy capacity calculating means 108 will be described below.

If the time interval of communication data is dense (for example, 1 s or less), the SOC calculating means 107 divides the data for each traveling and each charge. On the other hand, when the time interval of the communication data is long, the data during charging is divided by the charger.

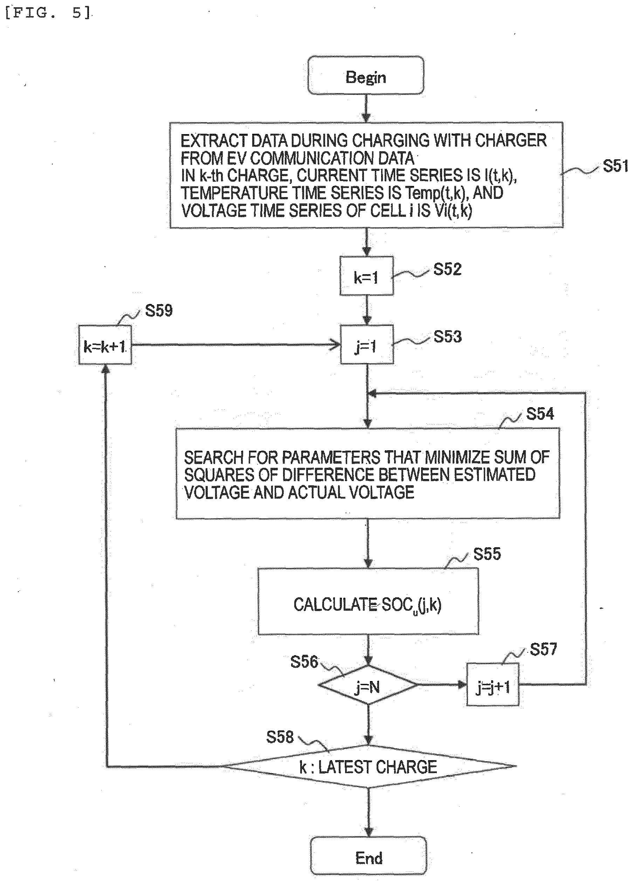

Fig. 5 illustrates a flowchart of the SOC calculating means 107 of Fig. 1.

In Fig. 5, the processing in the SOC calculating means 107 includes a data-during-charge extraction step of S51, a charge number initialization step of S52, a cell number initialization step of S53, a SOC solution obtaining step of S54, a cell loop end determination step of S56, a cell number up step of S57, a charge number end determination step of S58, and a charge number up step of S59.

As illustrated in this drawing, in step S51, data during charging (current, voltage of each cell, temperature) with the charger is acquired. These data are assumed as I(t, k), Vⱼ(t, k), and Temp(t, k), respectively (j = 1, ... ,N). Here, t is the time from the start of charging with the charger, and k is the number of times the battery has been charged with the charger. J indicates the cell number. Since there are M temperature sensors, an average value of M sensors may be used for Temp.

Next, in step S52, the oldest charge number (data during charging with the charger) k is set to 1. Then, in step S53, the cell number j is set to 1.

In step S54, represented by the following formula (2), using the following formulas (3), (4), and (5), parameters Pⱼ(k), Qⱼ(k), SOCI(j,k), and Qₘₐₓ(j,k) that minimize the sum of squares of the difference between the estimated voltage Vestⱼ(t) of cell j and the real voltage Vrealⱼ(t) of cell j are obtained.
[Formula 2] ${argmin}_{{P}_{j} \left(k\right) , {Q}_{j} \left(k\right) , SOCI \left(j, k\right) , {Q}_{max} \left(j, k\right)} \int {\left|{Vest}_{j}\left(t\right)-{Vreal}_{j}\left(t\right)\right|}^{2} dt$
[Formula 3] ${Vreal}_{j} \left(t\right) = OCV \left({SOC}_{j}\left(t\right)\right) + {R}_{c} \left(Temp, {SOC}_{j}\left(t\right)\right) \times I \left(t\right)$
[Formula 4] ${R}_{c} \left(Temp, SOC\right) = \left\{{P}_{j}\left(k\right)\times {R}_{fc}\left(SOC\right)+{Q}_{j}\left(k\right)\right\} \times exp \left\{B/\left(Temp+273.15\right)-B/\left(25+273.15\right)\right\}$
[Formula 5] ${SOC}_{j} \left(t\right) = SOCI \left(j, k\right) + 100 \times \frac{\int I \left(t\right) dt}{{Q}_{max} \left(j. k\right)}$

Here, Pⱼ(k) is the coefficient of charge resistance of each cell. Qⱼ(k) is the coefficient of charge resistance of each cell. SOCI(j,k) is an initial value of SOC of cell j that has been charged k times. Qₘₐₓ(j,k) is the electric charge capacity (Ah capacity) of cell j. R_{fc}(SOC) is the 25°C standard resistance function on the charging side. R_{c} is the charge resistance of each cell. The argmin in the above formula (2) means a function for obtaining a parameter that gives the minimum value. An actual solution for obtaining argmin may use the quasi-Newton method (Takehiko Kishine et al., "Memory-restricted quasi-Newton method with sizing effect", 2001 Japan Operations Research Society, Autumn Conference).

Next, in step S55, the amount of unbalance of cell j (SOC of each cell when the battery pack is fully charged, hereafter, referred to as SOCᵤ(j,k)) is calculated.

The electric charge (charging) when cell j is fully charged is expressed by the following formula. SOCIⱼ is an initial SOC of cell j and Qmaxⱼ is the electric charge capacity (Ah capacity) of cell j. $\left(1-{SOCI}_{j}\div 100\right) x {Qmax}_{j}$

Since the battery pack is fully charged when any one cell is fully charged, the battery pack is fully charged when electric charge Q_{f} expressed by the following formula is charged.${Q}_{f} = min \left[\left(1-{SOCI}_{j}\div 100\right) x {Qmax}_{j}\right]$

Therefore, the SOC of each cell when the battery pack is fully charged is expressed by the following formula.$SOC = {SOCI}_{j} + 100 x {Q}_{f} / {Qmax}_{j}$

The SOC of cell j at this time is the amount of unbalance (denoted as SOCᵤ(j)). When the unbalance state is eliminated, the amount of unbalance becomes 100% for all cells. This results in the maximum energy capacity of the battery pack when the unbalanced amount of all cells is 100%.

Therefore, the arithmetic expression is represented by the following formulas (6) and (7). The amount of unbalance SOCᵤ(j,k) of cell j is the SOC of each cell when the battery pack is fully charged. Q_{f}(k) is the electric charge (Ah) until the battery pack is fully charged, that is, any cell is fully charged.
[Formula 6] ${SOC}_{u} \left(j, k\right) = 100 \frac{{Q}_{f} \left(k\right)}{{Q}_{max} \left(j, k\right)} + SOCI \left(j, k\right)$
[Formula 7] ${Q}_{f} \left(k\right) = {min}_{j} \left\{{Q}_{max}\left(j, k\right)\times \left(1-\frac{SOCI \left(j, k\right)}{100}\right)\right\}$

Next, in step S56, it is determined whether or not the cell number j has reached the number of series N of cells. When the cell number becomes N, the processing moves to step S58. If not, in step S57, the cell number is incremented by one, and step S54 is repeated. In step S58, it is determined whether or not the charge number is the latest charge, and if Yes, the processing proceeds to step S59 and then to step S53. Otherwise, the processing ends.

The processing of Fig. 5 is performed periodically, for example, every day. Charging data that has already been processed is excluded from targets. This drawing illustrates the processing for one vehicle, but if there are a plurality of vehicles, the processing is performed for the number of vehicles.

After the processing in this drawing, not only the SOC time series of each cell, but also the initial value of the SOC for each charge, the coefficients Pⱼ(k), Qⱼ(k), and Qₘₐₓ(j,k) of resistance are obtained. Pⱼ(k) and Qⱼ(k) are constants in the formula (4.) above. These pieces of information are stored in the DB of the SOC data group 109.

Next, the SOC (denoted as SOCₑ(j)) at which each cell j stops discharging when discharged at a constant current is obtained. Since the discharge of the battery pack ends when any one of the cells reaches the minimum voltage Vₘ, SOCₑ(j) is obtained by solving the following nonlinear equation.${V}_{m} = OCV \left({SOC}_{e}\left(j\right)\right) - {I}_{d} x {R}_{d} \left({SOC}_{e}\left(j\right)\right)$ where I_{d} is the discharging current, R_{d} is the current discharge resistance, and is a function of SOC.

That is, R_{d} is obtained by multiplying the standard value of the discharge resistance table stored in the battery table 104 by the resistance coefficient Pⱼ described above and adding Qⱼ. If the initial value for discharge is SOCᵤ(j), since the relationship is SOCₑ(j) = SOCᵤ(j) - 100 x Q/Qmaxⱼ, the discharging electric charge Q_{d}(j) of cell j is expressed by the following formula.${Q}_{d} \left(j\right) = \left\{{SOC}_{u}\left(j\right)-{SOC}_{e}\left(j\right)\right\} x {Qmax}_{j} \div 100$

Since the battery pack stops discharging when any one cell reaches the minimum voltage, the battery pack stops discharging when Q_{d} expressed by the following formula is discharged.${Q}_{d} = min \left[\left\{{SOC}_{u}\left(j\right)-{SOC}_{e}\left(j\right)\right\} x {Qmax}_{j}\div 100\right]$

Therefore, the range of SOC for cell j is from SOCᵤ(j) to SOCᵤ(j) - 100xQ_{d}/Qmaxⱼ. An average value Vaⱼ of a voltage vⱼ(t) of the cell j within this SOC integration range is expressed by the following formula (8).
[Formula 8] ${Va}_{j} = \int \left\{OCV\left({SOC}_{j}\left(t\right)\right)-{I}_{d}\times {R}_{d}\left({SOC}_{j}\left(t\right)\right)\right\} dt$

As a result, the energy capacity Pₘₐₓ of the battery pack can be calculated using the following formula (9).
[Formula 9] ${P}_{max} = \sum {Va}_{j} \times {Qmax}_{j}$

The above calculation result is used as the current battery pack energy capacity. Then, similar calculations are performed with SOCᵤ(j) set to 100 to calculate the battery pack energy capacity after unbalance is eliminated. These values can be calculated and notified to the user.

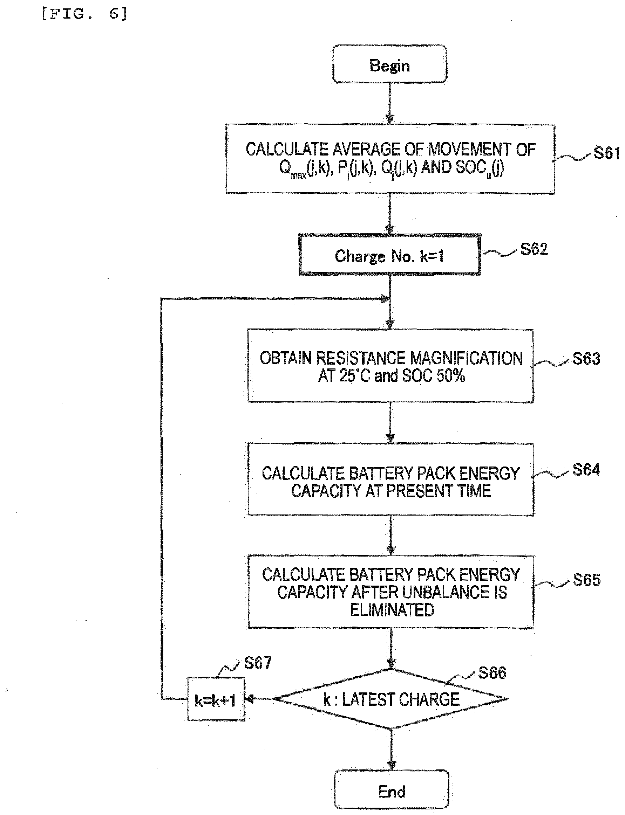

Based on the above principle, a flowchart illustrating an example of processing in the battery pack energy capacity calculating means 108 of Fig. 1 is illustrated in Fig. 6.

The processing in this drawing need not be synchronized with the processing in Fig. 5, and the calculation may be performed when the user wants to know the energy capacity of the battery pack and the calculation may be performed once a day or once a week.

The processing in this drawing includes a moving average step of S61, a charge number initialization step of S62, a cell number initialization step of S63, a current battery pack energy capacity calculation step of S64, an energy capacity after balancing is eliminated calculation step of S65, a cell loop end step of S66, and cell number up step of S67.

First, in step S61, a moving average value of Qₘₐₓ(j,k) accumulated in the SOC data group 109 is calculated for k. At this time, the following formulas (10) and (11) are the ratio of "variance of SOC x number of data". The reason why the ratio of "variance of SOC x number of data" is used is that data with a small SOC change width or a small number of data have a large error, so the weight wₖ of data with a large error is reduced. Step S61 may be omitted.
[Formula 10] ${Q}_{max} = {\sum }_{k} {Q}_{max} \left(k\right) {w}_{k}$
[Formula 11] $\begin{matrix}{w}_{k} = \frac{{\sum }_{t ∈ N \left(k\right)} {\left(SOC\left(k, t\right)-\overline{SOC \left(k\right)}\right)}^{2}}{{\sum }_{k} {\sum }_{t ∈ N \left(k\right)} {\left(SOC\left(k, t\right)-\overline{SOC \left(k\right)}\right)}^{2}} \\ where N \left(k\right) is the time set included in charge data k \\ \overline{SOC \left(k\right)} is the moving average value of SOC \left(k, t\right) at time set \\ N \left(k\right)\end{matrix}$

In step S61, also for Pⱼ(k), Qⱼ(k), and SOCᵤ(j), moving average values are calculated by the same method as the above formulas (10) and (11).

Next, in step S62, the charge number k is set to 1. In step S63, the magnification of how many times the current charge resistance of each cell at 25°C, SOC 50% is compared to the standard charge resistance at 25°C, SOC 50% is obtained from Pⱼ(k) and Qⱼ(k). This magnification is considered to be the same as the magnification of the discharge resistance and is used when determining the energy capacity of the battery pack during discharging.

This can be obtained as Pⱼ(k) + Qⱼ(k)/R_{f}(SOC 50%) using the standard resistance table R_{f}(SOC) at 25°C. Although SOC is set to 50%, it does not necessarily have to be SOC 50%, and any value of the SOC that matches the discharge resistance and the charge resistance may be used.

Next, in step S64, the current battery pack energy capacity is calculated. This finds the SOC when the cell j reaches the minimum voltage Vₘ (hereinafter described as SOCₑ(j)) when each cell is discharged at a temperature Temp and a constant discharge I_{d}. Note that SOCₑ can be obtained from SOCᵤ. Specifically, when discharging each cell, the SOC of each cell is obtained as SOCᵤ(j,k) - 1000/Q(j,k). Here, Q is the discharge Ah capacity of the battery pack. Since the voltage of each cell is OCV (SOC of cell j) - I x discharge resistance (temperature, SOC of cell j), it is sufficient to solve the equation where the voltage becomes Vₘ. The discharge resistance in this case is obtained by multiplying the standard resistance table of 25°C by the magnification of the charge resistance described above.

Then, it is the total sum of the products obtained by integrating the cell voltages from SOCₑ(j) to SOCᵤ(j) and multiplying them by Qₘₐₓ(j,k).

Here, the calculation of this battery pack charging electric charge will be described.

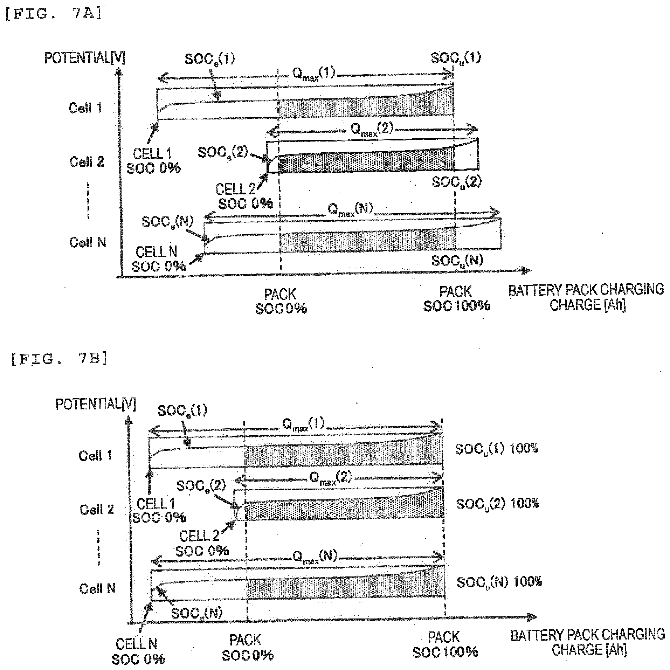

Fig. 7A is a graph illustrating the voltage of each cell in a state where an unbalance state is generated in the battery pack. The horizontal axis represents the amount of discharge of the entire battery pack, and the vertical axis represents the voltage of each cell.

In this figure, the curve SOCₑ(j) of each cell j (j = 1, ..., N) is illustrated. Normally, curves SOCₑ(j) do not coincide with each other at the left and right ends thereof. This is the unbalance state.

As illustrated in this drawing, since each cell is in an unbalance state, when the battery pack is fully charged, the SOCᵤ of each cell is not the same and the values are different. The SOC of each cell when the battery pack is empty is SOCₑ. Therefore, the integrated value of the voltage of each cell from SOCₑ to SOCᵤ (portions shaded in gray in this drawing) becomes the energy capacity of each cell. The energy capacity of the entire battery pack is calculated as the total sum of the energy capacities of each cell.

In step S65 of Fig. 6, the energy capacity after unbalance is eliminated is calculated. This is a similar calculation of the battery pack energy capacity assuming that the unbalance state is eliminated (SOCᵤ(j) 100%).

Fig. 7B is a graph illustrating the voltage of each cell after unbalance state of the battery pack is eliminated.

As illustrated in this drawing, if the unbalance state is eliminated, since the integrated value of the voltage of each cell from SOCₑ to SOCᵤ increases, the usable energy capacity of the battery pack as a whole is increased.

In step S66 of Fig. 6, it is determined whether or not it is the latest charge, and if not, the charge number is incremented by one in step S67, and the processing proceeds to step S63. When the latest charge number is reached, the processing is ended.

The energy capacity of the battery pack and the energy capacity of the battery pack after the unbalance state is eliminated are notified to the user.

### (Second Embodiment)

In this embodiment, the table setting means 105 of Fig. 1 will be described. There are three tables of an OCV table, a charge resistance table, and a discharge resistance table. First, a setting means of the OCV table will be described, and then a setting means of the charge resistance table and a setting means of the discharge resistance table will be described.

The setting means of the table changes for each pattern of a pattern of whether or not the representative SOC of the battery pack is present in the communication data, a pattern of whether or not to perform a battery pack capacity check test for a new vehicle, and a pattern of whether or not the positive and riegative electrode materials are known. Here, the battery pack capacity check test is a test in which the battery pack is fully charged and then discharged with a minute constant current until the battery pack is empty.

As for the method of automatic generation of the table, the OCV table is first created using communication data of a full charge test of the new vehicle. When the representative SOC of the battery pack is in the communication data, the OCV table is created from the information on each cell voltage and battery pack SOC before and after parking in the past. After the OCV table is obtained, if there is no discharge resistance table or charge resistance table, the communication data of the full charge test of a new vehicle (time series of current of the battery pack, voltage of each cell, and temperature) will be used to create the discharge resistance table. Further, the stored communication data is searched, and the charge resistance table is created from data of the representative SOC of the battery pack, the current during charging with the charger, and the voltage and temperature of each cell.

Here, the representative SOC of the battery pack refers to the SOC of the selected cell by the BMU from a plurality of cells included in the battery pack. It is unknown which cell the BMU has selected.

First, a case will be described in which the representative SOC of the battery pack is present in the communication data and the battery pack capacity check test for a new vehicle is performed. In this case, it is assumed that the new vehicle travels to some extent and the EV data has been accumulated although the energy capacity of the battery pack cannot be calculated yet.

In this case, each cell voltage immediately after parking (after charging with a charger, for example, it may be after 1000 seconds or after 1500 seconds) is extracted (except for the EV, data before and after it is operated for a while after arrival and the charging and discharging of the power storage system is stopped) from the communication data in the range from the state of the new vehicle to the state of traveling for a while. Then, the SOC at that time is plotted on the horizontal axis and each cell voltage is plotted on the vertical axis. In fact, the plotting is not required because the processing is performed by software, but is expressed as plotting for the explanation. Here, since the value of the representative SOC of the battery pack itself has an error and it is the value of the representative SOC of the battery pack, it is not the SOC value of each cell.

In this way, the data are scattered in the graph in which all the cell voltage data and the representative SOC of the battery pack are plotted. In other words, the correlation coefficient becomes lower. From this scattered data, OCV(SOC), which is a function from which OCV is obtained with respect to SOC, is identified. This operation is called "function approximation". Types of function approximation include a method using a spline function, a method using a piecewise linear function passing through each point, and a method using a neural network. In addition, there is a method for determining an unknown parameter a so that a squared error and absolute value error between the data and the value obtained by the function is minimized using a function with prescribed arguments and unknown parameters, as in F(x;a) (for example, F = ax² - 10), and identifying the function.

A case of using the spline function and the method for identifying a function by the function with arguments and unknown parameters prescribed by F(x;a) will be described below, respectively.

First, the method for performing function approximation with a spline will be described.

A relationship table between the SOC and OCV may be created by averaging SOC only with data at the same voltage or averaging voltages only with data at the same SOC. In this case, the OCV and SOC may be subjected to functional approximation by the spline.

Next, the method for identifying a function with the function with arguments and unknown parameters prescribed by F(x;a) will be described. Separately, if the materials for the positive and negative electrodes are known, since the potential for each discharge amount of the positive and negative electrodes can be known, function approximation may be performed using a potential difference between the positive and negative electrodes as the OCV.

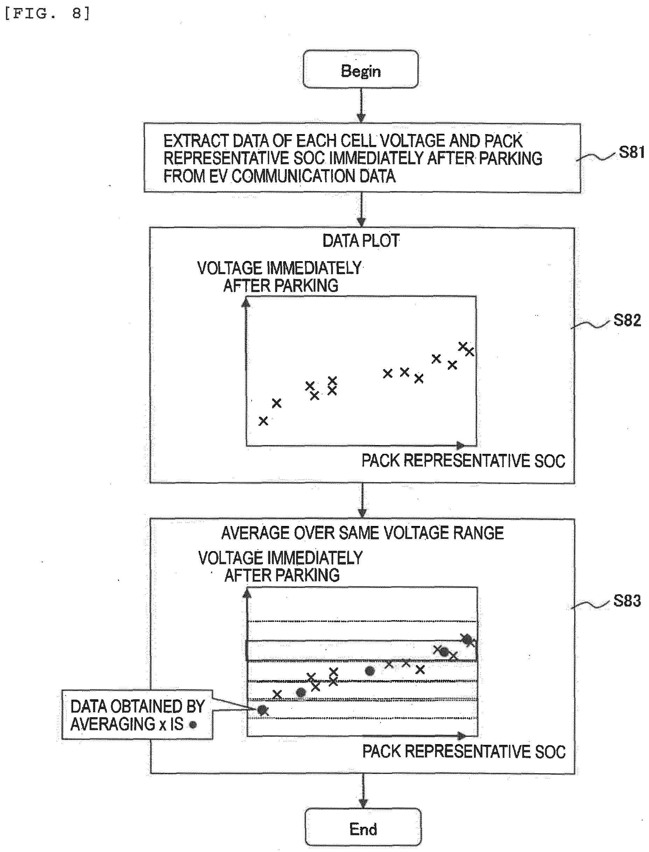

Based on the above principles, a flowchart illustrating an example of a method for setting the OCV table of the battery table in the battery pack diagnosing system is illustrated in Fig. 8. In Fig. 8, the function approximation by the spline and the method for identifying a function by the function with arguments and unknown parameters prescribed by F(x;a) are illustrated, respectively.

In this drawing, the method for setting the OCV table in the battery table includes a data-immediately-after-parking extraction step of S81, a data plotting step of S82, and an averaging step of S83.

As illustrated in this drawing, in step S81, data of each cell voltage and representative SOC of the battery pack immediately after parking is extracted from a log of EV communication data. Here, since there is a possibility that an unbalance state of the cell occurs, voltage data determined to be an outlier by the Smirnov-Grubbs' test (Hiroshi Takeuchi et al., "Statistics Dictionary", Toyo Keizai Inc.) or Dixon's test method (G.K. Kanji "Reverse Statistics", Kodansha August 20, 2015, 3rd edition) is removed.

Next, in step S82, each cell voltage immediately after parking (for example, 1500 seconds after finishing charging with the charger) and the representative SOC of the battery pack at that time are plotted. Actually, this step is not executed because this step is automatically processed by the program, but this step is provided for description.

Next, in step S83, a voltage data range is divided, and data within respective ranges are averaged. In the drawing, black circles in the graph of step S83 are the average data. Here, both the SOC and voltage are averaged. Then, the black circles are set as data of the OCV(SOC). Here, if the voltage at SOC 0% and the voltage at SOC 100% are provided, those data are added to the SOC.

The function OCV(SOC) is prescribed by interpolating the black circle by a spline or piecewise linear.

The method in this drawing is processing when the function OCV is unknown.

Next, if the materials of the positive and negative electrodes are known separately and the potential table for the respective single material of the positive and negative electrodes is known, the function OCV can be prescribed, and thus, step S83 is function approximation. In this case, when using the potential table, the function OCV is obtained by function approximation with the magnification of the discharge resistance for each SOC in the potential table and the amount of discharge deviation between the positive and negative electrodes as unknown parameters.

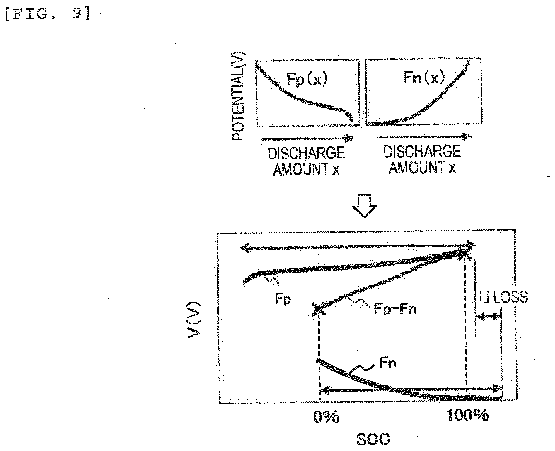

An overview of this processing will be described with reference to Fig. 9.

Fig. 9 is a diagram illustrating an example of function approximation of the OCV of the battery table using discharge curve analysis.

In the upper part of this drawing, a function Fₚ(x) of the positive electrode potential and a function Fₙ(x) of the negative electrode potential are each illustrated as separate graphs. The horizontal axis x is the amount of discharge [Ah/g], and the vertical axis is the potential [V]. Fₚ(x) and Fₙ(x) are given as table data.

Here, when considering the deviation of discharge, the positive electrode capacity, the negative electrode capacity, and the Li loss can be obtained by a predetermined calculation. Further, x and SOC have a linearrelationship.

Therefore, the function OCV is represented by the following formula. ap, sp, an, and sn are constants.$OCV = {F}_{p} \left(ap\times x-sp\right) - {F}_{n} \left(an\times x-sn\right)$

Here, since the relationship between the SOC and discharge amount x is a linear relationship, if x = p x SOC + q (p and q are constants), the OCV can be expressed by the following formula.$OCV \left(SOC\right) = {F}_{p} \left(ap\times \left(p\times SOC+q\right)-sp\right) - {F}_{n} \left(an\times \left(p\times SOC+q\right)-sn\right)$

This function OCV can be rewritten as the following formula (12) by setting Bₚ = ap x q - sp, Aₚ = -ap x p, Bₙ = an x q - sn, and Aₙ = -an x p.
[Formula 12] $OCV \left(SOC\right) = {F}_{p} \left({B}_{p}-{A}_{p}\times SOC\right) - {F}_{n} \left({B}_{n}-{A}_{n}\times SOC\right)$

Further, by substituting 0 or 100 for SOC in the above formula (12), the following formulas (13) and (14) are obtained.
[Formula 13] $OCV \left(0\right) = {F}_{p} \left({B}_{p}\right) - {F}_{n} \left({B}_{n}\right)$
[Formula 14] $OCV \left(100\right) = {F}_{p} \left({B}_{p}-100{A}_{p}\right) - {F}_{n} \left({B}_{n}-100{A}_{n}\right)$

In the formula, OCV(0) is the value given by OCV at SOC 0%. OCV(100) is a value given by OCV at SOC 100%.

In the lower part of this drawing, the positive electrode potential Fₚ, the negative electrode potential Fₙ and (Fₚ - Fₙ) (= OCV) are represented in one graph. In the above formulas (12), (13), and (14), OCV(0) and OCV(100) are constrained by potentials at SOC 0% and SOC 100%, respectively. In other words, it is constrained by the leftmost and rightmost values of the curve (Fₚ - Fₙ).

Since the values of OCV(0) and OCV(100) are given, OCV becomes a function with two indefinite parameters, with substantially two out of four indefinite parameters of Bₚ, Bₙ, Aₚ, and Aₙ disappearing. A function approximation of the OCV (SOC, unknown parameters) is performed to identify the indefiniteness of the remaining two parameters.

Specifically, actual data of OCV(SOC) is set to OCVᵣₑₐₗ(SOC), and an unknown parameter that minimizes a function E defined by the following formula (15), for example, is searched.
[Formula 15] $E = {\sum \left|{OCV}_{real}\left(SOC\right)-OCV\left(SOC, unknown parameter\right)\right|}^{2}$

Although the above formula (15) shows a squared error for the same SOC, it may be minimized using the distance between the curve given by the above formula (12) and paired actual data of OCV and SOC as a measure.

Here, since OCV(0) = Fₚ(Bₚ) - Fₙ(Bₙ), the unknown parameter Bₚ is represented by Bₙ in the following formula. ${B}_{p} = {{F}_{p}}^{- 1} \left(OCV\left(0\right)+{F}_{n}\left({B}_{n}\right)\right)$

Similarly, Aₚ is represented by Bₚ, Bₙ, and An from the formula of OCV(100) (Formula (14) above).

Since Bₚ is represented by Bₙ, Aₚ will be represented by Bₙ and Aₙ. That is, Bₙ and Aₙ are two unknown parameters. Further, Aₚ and Bₚ may be unknown parameters. Fₚ⁻¹ is an inverse function of Fₚ. Since Fₚ is a function represented by data and is represented by, for example, a spline function, the inverse function can be easily calculated using the spline function. In the following description, f⁻¹ represents an inverse function of f also for other functions f.

From the above formula (12) determined in this way, a value of eachOCV calculated by varying the SOC value from 0 to 100 is set in the OCV(SOC) in the battery table.

In addition, although the case where the voltage when it is at SOC 0% and SOC 100% is fixed is shown here, there may be cases where only the voltage at SOC 100% is fixed. In this case, the unknown parameters may be three of Aₙ, Bₙ, and Aₚ, or three of Aₙ, Bₙ, and Bₚ.

Furthermore, when information on the electric charge capacity (this is Q[Ah]) charged by the charger is present in the data, the following constraint is added. 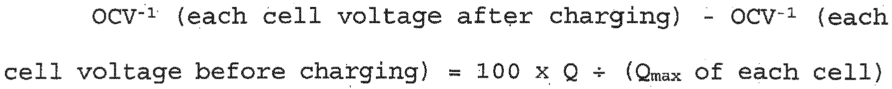 OCV-1 (each cell voltage after charging) - OCV-1 (each cell voltage before charging) = 100 x Q ÷ (Qmax of each cell)

In this case, instead of the above formula (15), in order to approach this constraint as much as possible, the unknown parameters An, Bn, and Qₘₐₓ of each cell may be obtained so that the following formula, which is the square of the difference between the left side and the right side of the formula of above constraint, is minimized, and the obtained An and Bn may be used. 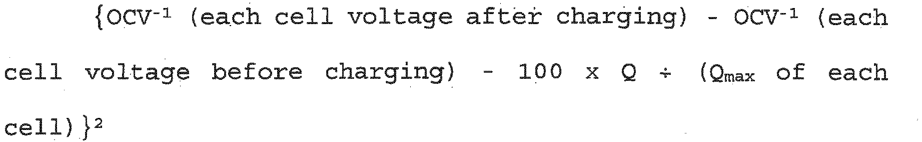 {OCV-1 (each cell voltage after charging) - OCV-1 (each cell voltage before charging) - 100 x Q ÷ (Qmax of each cell)}2

Next, a method for creating two types of tables including the charge resistance table and the discharge resistance table after the OCV table is set will be described.

First, the method for setting the charge resistance table (the argument of the function is SOC) will be described. Here, it is necessary to obtain the SOC of each cell first, and it is assumed that the representative SOC of the battery pack has been obtained.

Next, data on current, voltage, and temperature during charging are acquired by the charger, and based on these data, SOC is plotted on the horizontal axis and cell charge resistance is plotted on the vertical axis. Here, the cell charge resistance is expressed by the following formula. 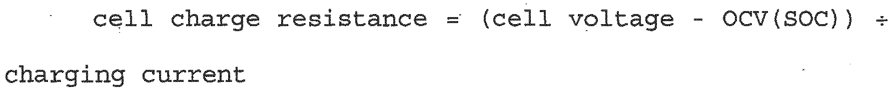 cell charge resistance = (cell voltage - OCV(SOC)) ÷ charging current

In addition, since an unbalance state may occur in each cell voltage, outlier voltage data is removed by the Smirnov-Grubbs' test or Dixon's test as described above. Since the parameter of the resistance includes temperature, a three-dimensional graph may be plotted. In this case, SOC is plotted on the x-axis, the temperature is plotted on the y-axis, and cell charge resistance is plotted on the z-axis.

Next, in function approximation, the following formula (16) is assumed.
[Formula 16] ${R}_{c} \left(SOC, {T}_{cell}\right) = exp \left\{B/\left({T}_{cell}+273.15\right)-B/\left(25+273.15\right)\right\} \times {R}_{c} \left(SOC,25°C\right)$

The above formula (16) is the Arrhenius equation, and B is called the temperature sensitivity here. T_{cell} is the temperature of the cell. R_{c} indicates charge resistance. Based on this assumption, if B is known, the actual charge resistance data and the cell temperature T_{cell} can be converted into the data of charge resistance at a temperature of 25°C. After conversion into the data at 25°C in this way, the charge resistance table may be set in the same manner as in the case of identifying OCV.

Here, since it is necessary to set B, only data of the same SOC are collected. Specifically, for example, data of SOC 32.5% or more and less than SOC 37.5% are regarded as data of SOC 35%, and the data are aggregated from SOC 5% to SOC 95%. Using the data regarded as the same SOC, data with temperature on the horizontal axis and charge resistance on the vertical axis is obtained, and B is identified by the least squares method, assuming a temperature function of the above formula (16). An average value of each B from SOC 5% to SOC 95% may be used.

Next, a method for setting the charge resistance when there is no representative SOC of the battery pack will be described. In this case, the battery pack capacity check test of a new vehicle shall be carried out.

In the case of the capacity check test, after charging from SOC 0% to SOC 100%, the SOC of each cell before and after charging is obtained from the OCV table. Since the amount of charged electric charge (this amount of charged electric charge is assumed to be Q) can be obtained from the current during charging, the electric charge capacity of each cell can be calculated by dividing Q by the difference in SOC before and after charging.

By using the electric charge capacity Qmaxᵢ (i is the cell number) of each cell obtained in this way, the SOC of each cell during charging by a charger can be subsequently calculated by the formula (1).

If the SOC is known, this SOC can be used instead of the SOC of the battery pack, in the same way as the method described above. Here, it is assumed that although the value of Qmaxᵢ decreases due to the deterioration of the battery, the value of Qₘₐₓ does not change for several months.

Next, a case will be described where the materials for the positive and negative electrodes are known, a table of charge resistance and discharge resistance of the positive electrode, a table of charge resistance and discharge resistance of the negative electrode, and temperature sensitivities B of the positive and negative electrodes are also known.

In this case, using Aₙ, Bₙ, Aₚ, and Bₚ, which have been obtained by the discharge curve analysis described above, Rₚ(x) for the cell standard positive electrode resistance, and Rₙ(x) for the cell standard negative electrode resistance (Rₚ and Rₙ are functions given in advance by material property data), the cell standard 25°C resistance Rₛ (SOC, 25°C) is calculated by the following formula (17). This is a standard resistance of 25°C.
[Formula 17] ${R}_{s} \left(SOC,25°C\right) = {R}_{p} \left({B}_{p}-{A}_{p}\times SOC\right) + {R}_{n} \left({B}_{n}-{A}_{n}\times SOC\right)$

Conversely, if OCV is given first, Aₙ, Bₙ, Aₚ, and Bₚ are obtained from the OCV table and Fₚ(x) and Fₙ(x).

However, since the cell standard 25°C resistance Rₛ (SOC, 25°C) in the above formula (17) does not consider the bias of the resistance, the resistance is indefinite as an absolute value, and there are the expression of deterioration, variations for each cell, and temperature sensitivity, the resistance R_{cell}(T_{cell}) for each cell is actually expressed by the following formula (18) using cell constants A and C. This is not limited to the discharge curve analysis, and the same applies also to the case where the resistance is identified from the communication data.
[Formula 18] ${R}_{cell} \left({T}_{cell}\right) = \left\{A\times {R}_{cell}\left(25°C\right)+C\right\} \times exp \left\{B/\left({T}_{cell}+273.15\right)-B/\left(25+273.15\right)\right\}$

The cell constants A and C in the above formula (18) are used here as undetermined. The identification method is identified by optimization in the SOC calculation process as described above.

### (Third Embodiment)

In the third embodiment, when the OCV table is set in the second embodiment, the OCV table setting processing and the discharge resistance table setting processing in a case where there is no representative SOC of the battery pack in the communication data and a case where the battery pack capacity check test of a new vehicle is performed will be described.

Since this test is for checking the energy capacity of the battery pack, the battery pack may be charged again after that, connected to a charging and discharging device, and subjected to a discharging test.

First, the battery pack electric charge capacity check test is performed. A light or an air conditioner is attached to the EV and it is discharged until the battery pack is empty.

A pause time (for example, 20 minutes or more) is set, and the battery pack is connected to the charger and fully charged. At this time, the voltage of each cell and the pack current of the battery pack are obtained by communication. After the end of charging, the electric charge capacity Q_{pack,max} of the battery pack is obtained by time-integrating the current of the battery pack. From that Q_{pack,max}, the battery pack is discharged for a certain period of time using the light or the air conditioner, and then pause is repeated to set the SOC of the battery pack to 0.

Here, the reason for setting the pause time is as follows. When the battery is charged and discharged, voltage fluctuations occur due to polarization, which deviates from the OCV. A long time (approximately 1000 seconds depending on the battery) elapses since the battery is stopped charging and discharging, and the polarization reaches 0 V. Therefore, by inserting a pause of about 1000 seconds (about 20 minutes or more), the voltage is made to match the OCV.

After the end of this test, the battery pack current is integrated using the log of the communication data, a battery pack current integration (the initial value is set to 0 when fully charged) at the end of the pause is plotted on the horizontal axis and each cell voltage immediately before the end of pause is plotted on the vertical axis. It can be converted to SOC by setting the horizontal axis to SOC = 100 - 100 x current integration ÷ current integration final value. An OCV table is created by performing function approximation on the data of the graph after this conversion. If the positive and negative electrode materials are known separately, similarly, the potential difference between positive and negative electrodes may be subjected to function approximation as a function of OCV.

In summary, the function data of OCV can be obtained by function approximation using the voltage and SOC of each cell before and after the paused state having no charge nor discharge of the battery pack.

In this case, the battery pack capacity check test for a new vehicle described above shall be performed. At this time, the electric charge capacity of the cell is known when the battery pack is charged from SOC 0% to 100%. A cell in which an unbalance state occurs has a low voltage when fully charged, and thus, the cell is excluded from the aggregation. Therefore, the SOC of each cell is 100 x integration of charging current ÷ full charge capacity of the cell.

The voltage during the time when discharge by the air conditioner and the light is performed for a fixed time may be used as OCV as it is.

As an effect of this, OCV can be set even if the information of SOC is not present in the communication data.

Next, a method for creating the charge resistance table and the discharge resistance table after identifying the OCV table will be described.

First, the method for setting the charge resistance table (function argument is SOC) will be described. Here, it is desirable to obtain the SOC of each cell first, but if the representative SOC of the battery pack is obtained, this value may be used instead. If the representative SOC of the battery pack cannot be obtained, the battery pack capacity check test for the new vehicle described above shall be performed. In this case, since the electric charge capacity of the cell is known (a cell in which an unbalance state occurs is excluded from the aggregation because the voltage becomes low when fully charged) when the battery pack is charged from SOC 0% to 100%, the SOC of each cell is prescribed as 100 x integration of charging current ÷ full charge capacity of the cell.

Next, based on the data during the charging, SOC is plotted on the horizontal axis and the charge resistance is plotted on the vertical axis. Here, the charge resistance is obtained by calculating (cell voltage - OCV(SOC)) = charging current. This charge resistance is resistance under the condition of charging with a constant current, which is different from the resistance in a transient state.

Next, similarly to the method described above, a charge resistance table with SOC as an argument is created by function approximation. If there is a charge resistance table (function of electric charge capacity) for the respective single material of the positive and negative electrodes, function approximation of the charge resistance is performed in the same manner as described above. Here, although the difference from the function approximation of OCV is that the liquid resistance is unknown since this is a fixed constant not depending on SOC, it may be used as a bias B for function approximation.

After performing a function approximation of OCV with positive and negative potentials, the resistance table may be obtained by combining a function obtained by multiplying a positive electrode resistance table by a horizontal magnification and a function obtained by multiplying a negative electrode resistance table by a horizontal magnification and shifting a positive/negative shift amount.

Next, a method for setting a discharge resistance table with SOC as an argument will be described.

This discharge resistance table is required when calculating the energy capacity of the battery pack, which will be described later. High SOC data (for example, SOC 20% or more) is not required. Further, a resistance when discharged to a constant current or almost constant current is preferable.

Assuming that the battery pack capacity check test for a new vehicle described above was performed, first, the discharge resistance table is obtained in the same manner as the charge resistance, using the data when discharging to SOC 0% with the air conditioner and lights turned on and using the current and each cell voltage during that time. There is also an estimation method from accumulated data, while the EV is traveling during operation, but in this case, it is limited to a case where the time interval of communication data of the battery is approximately 1 second or less.

### (Fourth Embodiment)

In the first embodiment, the future energy capacity (hereinafter referred to as "capacity after unbalance is eliminated") is estimated after the unbalance state is eliminated, and the replacement time of the current battery pack is predicted. For this purpose, it is obtained by storing the past capacity time series after unbalance is eliminated, predicting the future based on that time series, and calculating the date and time when the capacity after unbalance is eliminated reaches the replacement criterion (for example, 80% or 70% of catalog energy capacity). This date and time is the replacement time of the battery pack.

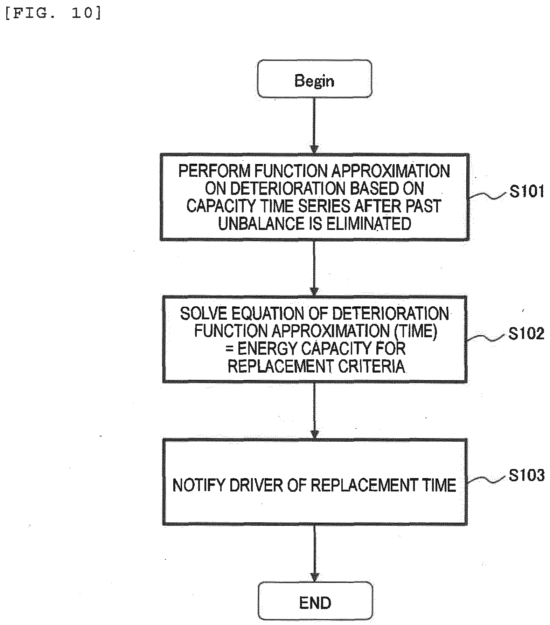

Fig. 10 is a flowchart illustrating an example of a method for calculating the replacement time of the battery pack.

First, in step S101, the deterioration is subjected to function approximation based on the capacity time series after unbalance is eliminated in the past. Here, the function obtained by approximation is referred to as a "function indicating deterioration of the battery pack".

As the method for predicting the future, it may be linearly approximated, or it may be approximated by the auto-regressive moving average (ARMA) or the Weibull distribution.

When the slope with respect to time (referred to as the "slope of deterioration") is linearly approximated, the slope with respect to time is affected by the rapid charging frequency, average temperature of the battery, average SOC, parking time frequency, mileage, daily average charge Ah, and the like. For this reason, for the battery pack of the same model number, various vehicles are aggregated, and the slope of deterioration with respect to time is subjected to function approximation by the rapid charging frequency, the average temperature of a battery, the average SOC, the parking time frequency, the mileage, and the daily average charging Ah. This method of function approximation may be linear or may use a neural network.

Based on the function of the slope of deterioration created in this way, a life prediction function for another vehicle may be created with the battery of the same model number. Specifically, since the rapid charging frequency and the like in other vehicles are determined, the slope is determined based on that parameter.

Then, the replacement time is determined by the current energy capacity of the pack, the slope of deterioration, and the energy capacity of the replacement criterion. In other words, the replacement time is determined by solving the equation of life prediction function = (energy capacity of replacement criterion) (step S102) .

This replacement time is notified to the driver (step S103).

Further, a factor that contributes to the slope (for example, rapid charging frequency) may be extracted in the function of the slope of deterioration, and the factor may be notified to the user. Based on the notified factor, the user takes actions such as lowering the rapid charging frequency to extend the life of the battery, so to speak, providing guidance for the battery life extension. Further, when the slope of deterioration suddenly increases, the driver is notified. In other words, when the slope of deterioration (speed of progress) reaches a predetermined value or more, the driver is notified. By this notification, the user is informed of a sign that the battery will suddenly become unusable.

Here, when ARMA is used, the coefficient of each ARMA has only to be similarly subjected to function approximation by the rapid charging frequency and the like. When the deterioration of the capacity after unbalance is eliminated is approximated by the Weibull distribution, the energy capacity Pₘₐₓ of the battery pack is approximated by the following formula (19) or (20).
[Formula 19] ${P}_{max} = {P}_{max , ini} \times exp \left\{-{\left(t/τ\right)}^{m}\right\}$

In the formula, m is a positive constant, and when m < 1, it decreases sharply at first and then decreases slowly. When m > 1, it decreases gently at first, then sharply approaches 0, and becomes unusable. τ is the time constant. P_{max,ini} is the initial value of the energy capacity of the battery pack.
[Formula 20] ${P}_{max} = {P}_{max , ini} \times exp \left\{-{\left(t/{τ}_{1}\right)}^{m}\right\} \times exp \left\{-{\left(t/{τ}_{2}\right)}^{2}\right\}$

In the formula, m and n are positive constants, m < 1, and n > 1. τ₁ and τ₂ are time constants.

The above formula (19) indicates a function that decreases sharply at the beginning, as seen in an ordinary lithium-ion battery, or a function that indicates the type of deterioration that suddenly becomes unusable due to mechanical deterioration due to expansion and contraction of the negative electrode, such as a lithium-ion battery that uses silicon for the negative electrode.

The above formula (20) is a combination of functions representing the two characteristics.

When the above formula (19) is used, m and τ are identified by the capacity time series after unbalance is eliminated in the past. Function approximation of m and τ is further performed using the rapid charging frequency and the like.

When the above formula (20) is used, m, n, τ₁, and τ₂ are identified by the capacity time series after unbalance is eliminated in the past. Furthermore, m, n, τ₁, and τ₂ have only to be subjected to function approximation by the rapid charging frequency and the like.

When the above formula (20) is used, the timing of suddenly becoming unusable can be known from τ₁. Specifically, the timing when the time t reaches τ₁ is the timing when it suddenly becomes unusable.

### (Fifth Embodiment)

In the first embodiment, when the energy capacity of the battery pack (hereinafter referred to as "capacity before unbalance is eliminated") and the energy capacity of the battery pack after unbalance is eliminated (hereinafter referred to as "capacity after unbalance is eliminated") are estimated, a method for notifying the user will be described.

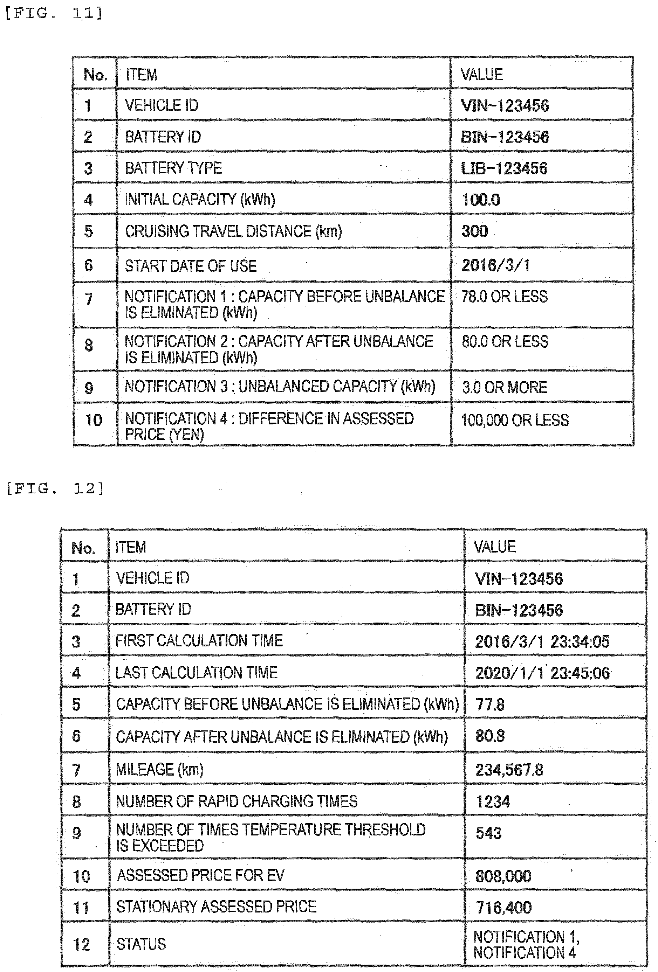

Fig. 11 is a table illustrating an example of a battery capacity table.

In this drawing, the vehicle ID of No. 1 indicates an identification number ID of the EV. The battery ID of No. 2 indicates an identification number ID of the battery built into the EV of the vehicle ID. The battery type of No. 3 indicates the type of the battery of No. 2. The initial capacity of No. 4 indicates the energy capacity or rated capacity of an initial battery pack. The initial cruising travel distance of No. 5 indicates a distance where cruising travel can be performed when the initial battery built into the EV is fully charged. The use start date of No. 6 indicates the date when the vehicle was shipped and sold and started to be used.

"Notification 1: capacity before unbalance is eliminated" of No. 7 indicates a threshold condition of the capacity before unbalance is eliminated when notifying the user. "Notification 2: capacity after unbalance is eliminated" of No. 8 indicates the threshold condition of the capacity after unbalance is eliminated when notifying the user. "Notification 3: unbalanced capacity'' of No. 9 indicates the threshold condition of the unbalanced capacity when notifying the user. Here, the unbalanced capacity is a value of the difference between the capacity after unbalance is eliminated and the capacity before unbalance is eliminated. "Notification 4: difference in assessed price" of No. 10 is a conditional value for the difference between the assessed price for EV and the assessed price for stationary use.

Here, the assessed price for EV refers to an assessed price when the battery pack is used for an EV. Further, the assessed price for stationary use refers to an assessed price when the battery pack is used for something other than an EV and is an assessed price of the battery pack when the battery pack is applied to a power storage device and the like for accumulating distributed energy.

Each item in this drawing is set in advance by input from the user.

No. 7 to No. 10 represent conditions for notifying the user and may be changed by input.

The conditions for making the notifications such as No. 7 to No. 10 in this drawing are set with the values such as the capacity before unbalance is eliminated, the capacity after unbalance is eliminated, the rate of change in capacity before unbalance is eliminated, the rate of change in capacity after unbalance is eliminated, the mileage of EV, the number of rapid charging times of the battery pack, the number of times the temperature threshold of the battery has been exceeded, the assessed price for EV, and the assessed price for stationary use, as the conditions. Here, the number of times the temperature threshold of the battery has been exceeded is the number of times the temperature of either the battery pack or the cells constituting the battery pack has exceeded the threshold.

In addition to these, a plurality of conditions can be added as AND conditions or OR conditions. For example, the conditions are when the condition that the capacity before unbalance is eliminated is 78.0 or less and the capacity after unbalance is eliminated is 80.0 or less is satisfied, when a condition that the mileage is 300,000 km or more and the capacity afterunbalance is eliminated is 80.0 or less is satisfied, when a condition that the number of rapid charging times is 3000 or more and the capacity after unbalance is eliminated is 80.0 or less is satisfied, when a condition that the number of times the temperature threshold has been exceeded is 1000 or more, or the capacity after unbalance is eliminated is 80.0 or less is satisfied, and the like. Further, the condition for the capacity before unbalance is eliminated of No. 7 or the capacity after unbalance is eliminated of No. 8 can be set as a condition of a ratio/percentage to the initial capacity of No. 4, or can also be set as a condition of a ratio/percentage of a current possible cruising travel distance to the initial cruising travel distance of No. 5. This is because the current possible cruising travel distance can be calculated from the current capacity before unbalance is eliminated.

Also, from the current capacity before unbalance is eliminated and the rate of change in capacity before unbalance is eliminated, the capacity after unbalance is eliminated in the future, for example, half a year later can be calculated and notified. Further, by calculating the future capacity after unbalance is eliminated, it is possible to predict the time when the value will fall below a preset threshold, such as 80.0, and notify the time.

Fig. 12 is a table illustrating an example of a battery diagnosis result table.

The vehicle ID of No. 1 indicates an identification number ID of the EV. The battery ID of No. 2 indicates an identification number ID of the battery built into the EV of the vehicle ID. The first calculation time of No. 3 indicates the date and time when the battery diagnosis calculation of this vehicle was performed for the first time. The last calculation time of No. 4 indicates the date and time when the battery diagnosis calculation of this vehicle was last performed.

No. 5 to No. 12 are set at the last calculation.

The capacity before unbalance is eliminated of No. 5 and the capacity after unbalance is eliminated of No. 6 are calculation results regarding the energy capacity of the battery pack.

No. 7 to No. 9 are vehicle or battery history data obtained by the server via communication from the EV when calculating the energy capacity of the battery pack, and No. 7 is mileage, No. 8 is the number of rapid charging times, and No. 9 is the number of times the temperature threshold has been exceeded. Here, the number of times the temperature threshold has been exceeded refers. to the number of times the temperature value of the temperature sensor attached to the on-vehicle battery was equal to or larger than a predetermined threshold temperature (for example, 65°C).

The assessed price for EV of No. 10 indicates a value obtained by estimating and calculating the selling price of the removed battery, which is currently built in the vehicle, as a battery for EV, No. 11 indicates a value obtained by estimating and calculating the selling price of the removed battery, which is currently built in the vehicle, as a battery for stationary use, and the status of No. 12 indicates an item whose calculation result should be notified.

When the capacity of the battery installed in a certain vehicle before and after unbalance is eliminated is calculated, a result notifying means (not illustrated) of the server 100 of Fig. 1 searches the battery diagnosis result table of Fig. 12 with the vehicle ID of No. 1 of the vehicle, updates the calculation end time of No. 4 with the current time, and also updates the capacity before unbalance is eliminated of No. 5 and the capacity after unbalance is eliminated of No. 6. Furthermore, the mileage of No. 7, the number of rapid charging times of No. 8, and the number of times the temperature threshold has been exceeded of No. 9, which are obtained by the server through communication from the EV are also updated. Furthermore, the calculation is performed with the capacity after unbalance is eliminated of No. 6, the mileage of No. 7, the number of rapid charging times of No. 8, and the number of times the temperature threshold has been exceeded of No. 9, the assessed price for EV of No. 10 and the assessed price for stationary use of No. 11 are also updated.

This calculation is calculated as a correlation function between data sold as the battery for EV in the past and price data sold as a battery for stationary use, and a history of the sold battery, that is, the capacity after unbalance is eliminated of No. 6, the mileage of No. 7, the number of rapid charging times of No. 8, and the number of times the temperature threshold has been exceeded of No. 9.

After the above update, the result notifying means searches the battery capacity table of Fig. 11 with the vehicle ID of No. 1 of the vehicle and examines the notification conditions of No. 7 to No. 9. If the updated value of the battery diagnosis result table in Fig. 12 matches the notification conditions, the user is notified. For the notification, a notification means of a normal computer or between computers, such as screen display, mail notification, and message notification is used. The fact that the notification to the user has been made is displayed in the status of No. 12.

For example, in Fig. 12, it is assumed that the capacity before unbalance is eliminated of No. 5 is calculated as 77.8 kWh, the capacity after unbalance is eliminated of No. 6 is calculated as 80.8 kWh, the assessed price for EV of No. 10 is calculated as 808,000 yen, and the assessed price for stationary use of No. 11 is calculated as 716,400 yen. As for these results, Notification 1 is notified because the condition for Notification 1 of No. 7 in Fig. 11 is 78.0 kWh or less. Further, since the condition of Notification 4 of No. 10 in Fig. 11 is 808,000 - 716,400 = 91,600 yen, which is less than 100,000 yen, Notification 4 is notified and is also displayed in the status of No. 12 in Fig. 12.

Hereinafter, the effects obtained from the present disclosure are described in summary.

A balancing circuit is incorporated in the battery management unit (BMU), and thus even if an unbalance state occurs, it will eventually be recovered by the balancing circuit. Therefore, if the energy capacity (true actual value) in the state where the unbalance is eliminated is calculated, it is possible to accurately estimate the replacement time of the battery pack.

A means for calculating not only the current energy capacity of the battery pack of the EV but also the energy capacity in a state where the unbalance state is eliminated can be provided.

A means for notifying when the battery pack should be replaced can be provided in consideration of the trend of the energy capacity.

The operation of measuring the state of the battery for creating the table can be made unnecessary. Further, by calculating the SOC variation and the electric charge capacity when fully charged for each cell, it is possible to obtain the energy capacity of the battery pack under a situation where the cell voltage is not uniform (a situation where balancing does not work well) or even under a situation where the electric charge capacity of the cell is not uniform.

### Reference Signs List

- 100:: server
- 101:: electric vehicle
- 102:: communication device
- 103:: storage device
- 104:: battery table
- 105:: table setting means
- 106:: in-operation battery pack energy calculating means
- 107:: SOC calculating means
- 108:: battery pack energy capacity calculating means
- 109:: SOC data group
- 201:: cell
- 202:: temperature sensor
- 203:: cell group
- 204:: ammeter
- 205:: battery management unit
- 206:: network
- 401:: OCV table
- 402:: charge resistance table
- 403:: discharge resistance table
- S51:: data-during-charge extraction step
- S52:: charge number initialization step
- S53:: cell number initialization step
- S54:: SOC solution obtaining step
- S56:: cell loop end determination step
- S57:: cell number up step
- S58:: charge number end determination step
- S59:: charge number up step
- S61:: moving average step
- S62:: charge number initialization step
- S63:: cell number initialization step
- S64:: current battery pack energy capacity calculation step
- S65:: energy capacity after balancing is eliminated calculation step
- S66:: cell loop end step
- S67:: cell number up step
- S81:: data-immediately-after-parking extraction step
- S82:: data plotting step
- S83:: averaging step

## Claims

1. A method for diagnosing a battery pack having a configuration in which a plurality of cells (201) are connected in series, using a system for obtaining detected data including the current and temperature of the battery pack and the voltage of each cell (201), the method comprising:
a step of calculating an electric charge capacity and a SOC (107) of each cell (201), using the current and the temperature, the voltage of each cell (201), an OCV-SOC function, and a resistance table (402), and calculating an amount of unbalance, which is an estimated value of the SOC (107), and a resistance of each cell (201) when the battery pack is fully charged; and
a step of calculating the energy capacity of the battery pack using the electric charge capacity, the amount of unbalance, and the resistance,
**characterized in that**
coefficients of the electric charge capacity, an initial value of the SOC (107), and the resistance of each of the cells (201) that minimize a difference between an estimated voltage and an actual voltage of each of the cells (201) are obtained.

2. The diagnosis method according to claim 1, wherein
the energy capacity of the battery pack is calculated by calculating both the current energy capacity and the energy capacity after unbalance is eliminated.

3. The diagnosis method according to claim 1, wherein
the SOC of each cell (201) when the battery pack is fully charged is obtained using an initial value of the SOC and the electric charge capacity of the cell (201) and an electric charge until any of the cells (201) is fully charged.

4. The diagnosis method according to claim 1, wherein
using a minimum voltage, a discharging current, an OCV table, and a discharge resistance table (403) with the time when the battery pack is discharged from a full charge and any of the cells (201) reaches the minimum voltage as the time when the discharge of the battery pack is ended, a discharge end SOC of each cell (201) is obtained, an average voltage of each cell (201) from the time of the full charge to the end of the discharge is obtained, and a total sum of the products of the average voltage and the electric charge capacity of each cell (201) is defined as the current energy capacity.

5. The diagnosis method according to claims 1 to 4, wherein
a user is notified of a result of determining whether or not a threshold condition for the energy capacity of the battery pack is satisfied.

6. The diagnosis method according to claim 1, wherein
a function indicating deterioration of the battery pack is obtained using data on the energy capacity of the battery pack,
a replacement time of the battery pack is predicted from this function, and
a user is notified of the replacement time.

7. The diagnosis method according to claim 6, wherein
a time when the speed of progress of the deterioration becomes equal to or greater than a predetermined value is predicted from the function indicating the deterioration, and the user is notified of the time.

8. The diagnosis method according to claim 4, wherein
the energy capacity after unbalance is eliminated (S65) is obtained by the same calculation as the calculation of the total sum of the products used when calculating the current energy capacity.

9. The diagnosis method according to claim 1, further comprising:
a step of obtaining function data of the OCV (401) for each cell (201); and
a step of creating the resistance table (402) of each cell (201) using the function data and the detected data.

10. The diagnosis method according to claim 9, wherein
the function data is obtained by function approximation using the voltage and the SOC of each cell (201) before and after a paused state having no charge nor discharge of the battery pack.

11. The diagnosis method according to claim 9, wherein
the detected data includes a representative SOC of the battery pack, and
the representative SOC is used as the SOC.

12. The diagnosis method according to claim 9, wherein
in the resistance table (402) of the cell (201), using past ones of the function data, the representative SOC (107), and the detected data, data of the resistance during charging of the cell (201) corresponding to each temperature and each SOC is obtained by function approximation as a value obtained by dividing the difference between the OCV and the voltage of the cell (201) by the current of the cell (201).

13. The diagnosis method according to claim 9, wherein
the voltage of each cell (201) is measured by performing a capacity check test of the battery pack, and
the function data of the OCV (401) is obtained using the voltage value.

14. The diagnosis method according to claim 9, wherein
when a positive electrode material and a negative electrode material of the cell (201) are known, the function data of the OCV is obtained by function approximation using a potential table of the positive electrode material and the negative electrode material.

15. The diagnosis method according to claim 14, wherein
the resistance table (402) is created using the function data of the OCV (401) obtained by the function approximation and a resistance table of the positive electrode material and the negative electrode material.

16. The diagnosis method according to claim 1, wherein
the battery pack is built into an electric vehicle,
the detected data is transmitted to a diagnosing device installed inside or outside the electric vehicle, and
the diagnosing device calculates the energy capacity of the battery pack.

17. The diagnosis method according to claim 16, wherein
the diagnosing device is installed outside the electric vehicle, receives the detected data of a plurality of the electric vehicles, and calculates the energy capacity of the battery pack of each of the electric vehicles.

18. The diagnosis method according to claim 1, wherein
the battery pack is built into an electric vehicle, and
a user is notified of a result of determining whether or not at least one of the mileage of the electric vehicle, the number of rapid charging times of the battery pack, the number of times the temperature of the battery pack exceeds a threshold, an assessed price when the battery pack is used in the electric vehicle, an assessed price when the battery pack is used in a vehicle other than the electric vehicle is satisfied as a threshold condition.

19. A device for diagnosing a battery pack, comprising:
a SOC calculation unit (107);
a battery pack energy capacity calculation unit (108); and
a storage device having a resistance table (402), wherein
the SOC calculation unit (107) calculates an electric charge capacity and the SOC of each cell (201) using the current and temperature of the battery pack having a configuration in which a plurality of cells (201) are connected in series, a voltage of each cell (201), an OCV-SOC function, and the resistance table (402), and calculates an amount of unbalance, which is an estimated value of the SOC, and a resistance of each cell (201) when the battery pack is fully charged, and
the battery pack energy capacity calculation unit (108) calculates the energy capacity of the battery pack using the electric charge capacity, the amount of unbalance, and the resistance,
**characterized in that**
coefficients of the electric charge capacity, an initial value of the SOC, and the resistance of each of the cells (201) that minimize a difference between an estimated voltage and an actual voltage of each of the cells (201) are obtained.

## Patentansprüche

1. Verfahren zum Diagnostizieren einer Batteriebaugruppe, die eine Konfiguration aufweist, in der mehrere Zellen (201) in Reihe geschaltet sind, unter Verwendung eines Systems zum Erhalten detektierter Daten, die den Strom und die Temperatur der Batteriebaugruppe und die Spannung jeder Zelle (201) enthalten, wobei das Verfahren umfasst:
einen Schritt des Berechnens einer Kapazität für elektrische Ladung und eines SOC (107) jeder Zelle (201) unter Verwendung des Stroms und der Temperatur, der Spannung jeder Zelle (201), einer OCV-SOC-Funktion und einer Widerstandstabelle (402) und des Berechnens eines Betrags der Unsymmetrie, der ein Schätzwert des SOC (107) ist, und eines Widerstands jeder Zelle (201), wenn die Batteriebaugruppe vollständig geladen ist; und
einen Schritt des Berechnens der Energiekapazität der Batteriebaugruppe unter Verwendung der Kapazität für elektrische Ladung, des Betrags der Unsymmetrie und des Widerstands,
**dadurch gekennzeichnet, dass**
Koeffizienten der Kapazität für elektrische Ladung, eines Anfangswerts des SOC (107) und des Widerstands jeder der Zellen (201), die eine Differenz zwischen einer geschätzten Spannung und einer tatsächlichen Spannung jeder der Zellen (201) minimieren, erhalten werden.

2. Diagnoseverfahren nach Anspruch 1, wobei
die Energiekapazität der Batteriebaugruppe durch Berechnen sowohl der aktuellen Energiekapazität als auch der Energiekapazität, nachdem die Unsymmetrie beseitigt worden ist, berechnet wird.

3. Diagnoseverfahren nach Anspruch 1, wobei
der SOC jeder Zelle (201), wenn die Batteriebaugruppe vollständig geladen ist, unter Verwendung eines Anfangswerts des SOC und der Kapazität für elektrische Ladung der Zelle (201) und einer elektrischen Ladung, bis irgendeine der Zellen (201) vollständig geladen ist, erhalten wird.

4. Diagnoseverfahren nach Anspruch 1, wobei
unter Verwendung einer Minimalspannung, eines Entladestroms, einer OCV-Tabelle und einer Entladewiderstandstabelle (403), wobei der Zeitpunkt, zu dem die Batteriebaugruppe von einer vollständigen Ladung entladen wird und irgendeine der Zellen (201) die Minimalspannung erreicht, als der Zeitpunkt angesehen wird, zu dem die Entladung der Batteriebaugruppe beendet ist, ein Entladeende-SOC jeder Zelle (201) erhalten wird, eine Durchschnittsspannung jeder Zelle (201) von dem Zeitpunkt der vollständigen Ladung bis zu dem Ende der Entladung erhalten wird und eine Gesamtsumme der Produkte der Durchschnittsspannung und der Kapazität für elektrische Ladung jeder Zelle (201) als die aktuelle Energiekapazität definiert wird.

5. Diagnoseverfahren nach den Ansprüchen 1 bis 4, wobei
ein Benutzer über ein Ergebnis der Bestimmung, ob eine Schwellenbedingung für die Energiekapazität der Batteriebaugruppe erfüllt ist, benachrichtigt wird.

6. Diagnoseverfahren nach Anspruch 1, wobei
unter Verwendung von Daten über die Energiekapazität der Batteriebaugruppe eine Funktion, die eine Qualitätsminderung der Batteriebaugruppe angibt, erhalten wird,
aus dieser Funktion eine Auswechselzeit der Batteriebaugruppe vorhergesagt wird, und
ein Benutzer über die Auswechselzeit benachrichtigt wird.

7. Diagnoseverfahren nach Anspruch 6, wobei
aus der Funktion, die die Qualitätsminderung angibt, ein Zeitpunkt, zu dem die Geschwindigkeit des Fortschritts der Qualitätsminderung gleich oder größer einem vorhergesagten Wert wird, vorhergesagt wird und der Benutzer über den Zeitpunkt benachrichtigt wird.

8. Diagnoseverfahren nach Anspruch 4, wobei
die Energiekapazität, nachdem die Unsymmetrie beseitigt worden ist (S65), durch dieselbe Berechnung wie die Berechnung der Gesamtsumme der Produkte, die beim Berechnen der aktuellen Energiekapazität verwendet wird, erhalten wird.

9. Diagnoseverfahren nach Anspruch 1, das ferner umfasst:
einen Schritt des Erhaltens von Funktionsdaten der OCV (401) für jede Zelle (201); und
einen Schritt des Erzeugens der Widerstandstabelle (402) jeder Zelle (201) unter Verwendung der Funktionsdaten und der detektierten Daten.

10. Diagnoseverfahren nach Anspruch 9, wobei
die Funktionsdaten durch Funktionsnäherung unter Verwendung der Spannung und des SOC jeder Zelle (201) vor und nach einem angehaltenen Zustand ohne Ladung oder Entladung der Batteriebaugruppe erhalten werden.

11. Diagnoseverfahren nach Anspruch 9, wobei
die detektierten Daten einen repräsentativen SOC der Batteriebaugruppe enthalten, und
der repräsentative SOC als der SOC verwendet wird.

12. Diagnoseverfahren nach Anspruch 9, wobei
Daten des Widerstands während des Ladens der Zelle (201), die jeder Temperatur und jedem SOC entsprechen, in der Widerstandstabelle (402) der Zelle (201) unter Verwendung früherer Funktionsdaten, des repräsentativen SOC (107) und der detektierten Daten durch Funktionsnäherung als ein Wert, der durch Dividieren der Differenz zwischen dem OCV und der Spannung der Zelle (201) durch den Strom der Zelle (201) erhalten wird, erhalten werden.

13. Diagnoseverfahren nach Anspruch 9, wobei
die Spannung jeder Zelle (201) durch Ausführen eines Kapazitätsprüfungstests der Batteriebaugruppe gemessen wird, und
die Funktionsdaten der OCV (401) unter Verwendung des Spannungswerts erhalten werden.

14. Diagnoseverfahren nach Anspruch 9, wobei
dann, wenn ein Material der positiven Elektrode und ein Material der negativen Elektrode der Zelle (201) bekannt sind, die Funktionsdaten der OCV durch Funktionsnäherung unter Verwendung einer Potentialtabelle des Materials der positiven Elektrode und des Materials der negativen Elektrode erhalten werden.

15. Diagnoseverfahren nach Anspruch 14, wobei
die Widerstandstabelle (402) unter Verwendung der Funktionsdaten der OCV (401), die durch die Funktionsnäherung erhalten werden, und einer Widerstandstabelle des Materials der positiven Elektrode und des Materials der negativen Elektrode erzeugt wird.

16. Diagnoseverfahren nach Anspruch 1, wobei
die Batteriebaugruppe in ein Elektrofahrzeug eingebaut ist,
die detektierten Daten an eine Diagnosevorrichtung, die innerhalb oder außerhalb des Elektrofahrzeugs eingebaut ist, gesendet werden, und
die Diagnosevorrichtung die Energiekapazität der Batteriebaugruppe berechnet.

17. Diagnoseverfahren nach Anspruch 16, wobei
die Diagnosevorrichtung außerhalb des Elektrofahrzeugs installiert ist, die detektierten Daten mehrerer der Elektrofahrzeuge empfängt und die Energiekapazität der Batteriebaugruppe jedes der Elektrofahrzeuge berechnet.

18. Diagnoseverfahren nach Anspruch 1, wobei
die Batteriebaugruppe in einem Elektrofahrzeug installiert ist, und
ein Benutzer über ein Ergebnis der Bestimmung, ob wenigstens eines der Laufleistung des Elektrofahrzeugs, der Anzahl von Schnellladungen der Batteriebaugruppe, der Anzahl, in der die Temperatur der Batteriebaugruppe einen Schwellenwert übersteigt, eines geschätzten Preises, wenn die Batteriebaugruppe in dem Elektrofahrzeug verwendet wird, eines geschätzten Preises, wenn die Batteriebaugruppe in einem anderen Fahrzeug als dem Elektrofahrzeug verwendet wird, als eine Schwellenbedingung erfüllt ist, benachrichtigt wird.

19. Vorrichtung zum Diagnostizieren einer Batteriebaugruppe, wobei die Vorrichtung umfasst:
eine SOC-Berechnungseinheit (107);
eine Batteriebaugruppen-Energiekapazitäts-Berechnungseinheit (108); und
eine Speichervorrichtung, die eine Widerstandstabelle (402) aufweist, wobei
die SOC-Berechnungseinheit (107) eine Kapazität für elektrische Ladung und den SOC jeder Zelle (201) unter Verwendung der Stroms und der Temperatur der Batteriebaugruppe, die eine Konfiguration aufweist, in der mehrere Zellen (201) in Reihe geschaltet sind, einer Spannung jeder Zelle (201), einer OCV-SOC-Funktion und der Widerstandstabelle (402) berechnet und einen Betrag der Unsymmetrie, der ein Schätzwert des SOC Werts ist, und einen Widerstand jeder Zelle (201), wenn die Batteriebaugruppe vollständig geladen ist, berechnet, und
die Batteriebaugruppen-Energiekapazitäts-Berechnungseinheit (108) die Energiekapazität der Batteriebaugruppe unter Verwendung der Kapazität für elektrische Ladung, des Betrags der Unsymmetrie und des Widerstands berechnet,
**dadurch gekennzeichnet, dass**
die Koeffizienten der Kapazität für elektrische Ladung, eines Anfangswerts des SOC und des Widerstands jeder der Zellen (201), die eine Differenz zwischen einer geschätzten Spannung und einer tatsächlichen Spannung jeder der Zellen (201) minimieren, erhalten werden.

## Revendications

1. Procédé de diagnostic d'un bloc batterie ayant une configuration dans laquelle une pluralité de cellules (201) sont connectées en série, en utilisant un système pour obtenir des données détectées incluant le courant et la température du bloc batterie et la tension de chaque cellule (201), le procédé comprenant :
une étape consistant à calculer une capacité de charge électrique et un SOC (état de charge) (107) de chaque cellule (201), en utilisant le courant et la température, la tension de chaque cellule (201), une fonction OCV (tension en circuit ouvert)-SOC et une table de résistance (402), et à calculer une quantité de déséquilibre, qui est une valeur estimée du SOC (107), et une résistance de chaque cellule (201) quand le bloc batterie est entièrement chargé ; et
une étape consistant à calculer la capacité énergétique du bloc batterie en utilisant la capacité de charge électrique, la quantité de déséquilibre, et la résistance,
**caractérisé en ce que**
des coefficients de la capacité de charge électrique, une valeur initiale du SOC (107), et la résistance de chacune des cellules (201), qui minimisent une différence entre une tension estimée et une tension réelle de chacune des cellules (201), sont obtenus.

2. Procédé de diagnostic selon la revendication 1, dans lequel
la capacité énergétique du bloc batterie est calculée en calculant à la fois la capacité énergétique actuelle et la capacité énergétique après élimination du déséquilibre.

3. Procédé de diagnostic selon la revendication 1, dans lequel
le SOC de chaque cellule (201), quand le bloc batterie est entièrement chargé, est obtenu en utilisant une valeur initiale du SOC et la capacité de charge électrique de la cellule (201) et une charge électrique jusqu'à ce que l'une quelconque des cellules (201) soit entièrement chargée.

4. Procédé de diagnostic selon la revendication 1, dans lequel
en utilisant une tension minimum, un courant de décharge, une table OCV, et une table de résistance de décharge (403) avec le moment où le bloc batterie est déchargé depuis une charge complète et où l'une quelconque des cellules (201) atteint la tension minimum à titre de moment où la décharge du bloc batterie est terminée, un SOC de fin de décharge de chaque cellule (201) est obtenu, une tension moyenne de chaque cellule (201) depuis le moment de la charge complète jusqu'à la fin de la décharge est obtenue, et une somme totale des produits de la tension moyenne et la capacité de charge électrique de chaque cellule (201) est définie à titre de capacité énergétique actuelle.

5. Procédé de diagnostic selon les revendications 1 à 4, dans lequel
un utilisateur est averti d'un résultat d'une détermination selon laquelle une condition seuil pour la capacité énergétique du bloc batterie est ou n'est pas satisfaite.

6. Procédé de diagnostic selon la revendication 1, dans lequel
une fonction indiquant une détérioration du bloc batterie est obtenue en utilisant des données concernant la capacité énergétique du bloc batterie,
un moment de remplacement du bloc batterie est prédit à partir de cette fonction, et
un utilisateur est averti du moment de remplacement.

7. Procédé de diagnostic selon la revendication 6, dans lequel
un moment où la vitesse de progression de la détérioration devient égale ou supérieure à une valeur prédéterminée est prédit à partir de la fonction indiquant la détérioration, et l'utilisateur est averti de ce moment.

8. Procédé de diagnostic selon la revendication 4, dans lequel
la capacité énergétique après élimination du déséquilibre (S65) est obtenue par le même calcul que le calcul de la somme totale des produits utilisé lors du calcul de la capacité énergétique actuelle.

9. Procédé de diagnostic selon la revendication 1, comprenant en outre :
une étape consistant à obtenir des données de l'OCV (401) pour chaque cellule (201) ; et
une étape consistant à créer la table de résistance (402) de chaque cellule (201) en utilisant les données de fonction et les données détectées.

10. Procédé de diagnostic selon la revendication 9, dans lequel
les données de fonction sont obtenues par approximation de fonction en utilisant la tension et le SOC de chaque cellule (201) avant et après un état de pause où il n'y a aucune charge ni décharge du bloc batterie.

11. Procédé de diagnostic selon la revendication 9, dans lequel
les données détectées incluent un SOC représentatif du bloc batterie, et
le SOC représentatif est utilisé à titre de SOC.

12. Procédé de diagnostic selon la revendication 9, dans lequel
dans la table de résistance (402) de la cellule (201), en utilisant des données passées des données de fonction, le SOC représentatif (107), et les données détectées, des données de la résistance pendant une charge de la cellule (201) correspondant à chaque température et à chaque SOC sont obtenues par approximation de fonction à titre de valeur obtenue en divisant la différence entre l'OCV et la tension de la cellule (201) par le courant de la cellule (201).

13. Procédé de diagnostic selon la revendication 9, dans lequel
la tension de chaque cellule (201) est mesurée en effectuant un test de contrôle de capacité du bloc batterie, et
les données de fonction de l'OCV (401) sont obtenues en utilisant la valeur de tension.

14. Procédé de diagnostic selon la revendication 9, dans lequel
quand un matériau d'électrode positive et un matériau d'électrode négative de la cellule (201) sont connus, les données de fonction de l'OCV sont obtenues par approximation de fonction en utilisant une table de potentiel du matériau d'électrode positive et du matériau d'électrode négative.

15. Procédé de diagnostic selon la revendication 14, dans lequel
la table de résistance (402) est créée en utilisant les données de fonction de l'OCV (401) obtenues par l'approximation de fonction et une table de résistance du matériau d'électrode positive et du matériau d'électrode négative.

16. Procédé de diagnostic selon la revendication 1, dans lequel
le bloc batterie est monté dans un véhicule électrique,
les données détectées sont transmises à un dispositif de diagnostic installé à l'intérieur ou à l'extérieur du véhicule électrique, et
le dispositif de diagnostic calcule la capacité énergétique du bloc batterie.

17. Procédé de diagnostic selon la revendication 16, dans lequel
le dispositif de diagnostic est installé à l'extérieur du véhicule électrique, reçoit les données détectées d'une pluralité des véhicules électriques, et calcule la capacité énergétique du bloc batterie de chacun des véhicules électriques.

18. Procédé de diagnostic selon la revendication 1, dans lequel
le bloc batterie est monté dans un véhicule électrique, et
un utilisateur est averti d'un résultat d'une détermination selon laquelle au moins un élément parmi le kilométrage du véhicule électrique, le nombre de recharges rapides du bloc batterie, le nombre de fois où la température du bloc batterie dépasse un seuil, un prix évalué quand le bloc batterie est utilisé dans le véhicule électrique, un prix évalué quand le bloc batterie est utilisé dans un véhicule autre que le véhicule électrique, satisfait ou ne satisfait pas à une condition seuil.

19. Dispositif de diagnostic d'un bloc batterie, comprenant :
une unité de calcul de SOC (107) ;
une unité de calcul de capacité énergétique de bloc batterie (108) ; et
un dispositif de stockage ayant une table de résistance (402), dans lequel l'unité de calcul de SOC (107) calcule une capacité de charge électrique et le SOC de chaque cellule (201) en utilisant le courant et la température du bloc batterie ayant une configuration dans laquelle une pluralité de cellules (201) sont connectées en série, une tension de chaque cellule (201), une fonction OCV-SOC, et la table de résistance (402), et calcule une quantité de déséquilibre, qui est une valeur estimée du SOC, et une résistance de chaque cellule (201) quand le bloc batterie est entièrement chargée, et
l'unité de calcul de capacité énergétique de bloc batterie (108) calcule la capacité énergétique du bloc batterie en utilisant la capacité de charge électrique, la quantité de déséquilibre, et la résistance,
**caractérisé en ce que**
des coefficients de la capacité de charge électrique, une valeur initiale du SOC et la résistance de chacune des cellules (201), qui minimisent une différence entre une tension estimée et une tension réelle de chacune des cellules (201), sont obtenus.
